# EUROPEAN PATENT APPLICATION

(11) **EP 4 818 729 A1**
(43) Date of publication of application: **07.10.2026**
(21) Application number: 25305501.6
(22) Date of filing: 04.04.2025
(51) Int. Cl.: G01R 33/28, G01R 33/31

(54) **CRYOSTAT, DNP DEVICE OR NMR SYSTEM COMPRISING SAID CRYOSTAT**

(71) Applicant: Université Claude Bernard Lyon 1 (UCBL), 69100 Villeurbanne (FR); Centre National de la Recherche Scientifique, 75016 Paris (FR); Ecole Normale Supérieure de Lyon (ENS de Lyon), 69007 Lyon (FR); BRUKER FRANCE (Société par Actions Simplifiée), 67160 Wissembourg (FR)
(72) Inventor: JANNIN, Sami, 1026 ECHANDENS (CH); VANEECKHAUTE, Ewoud, 69009 LYON (FR); STERN, Quentin, ILLINOIS, 60202 (US); BOCQUELET, Charlotte, 69200 VENISSIEUX (FR); ROUGIER, Nathan, 69100 VILLEURBANNE (FR); KEMPF, Jim, Massachusetts, 01821 (US); MELZI, Roberto, 20158 Milan (IT)
(74) Representative: IPAZ

(57) **Abstract**

The invention concerns a cryostat (8) comprising a sample chamber arranged for receiving a sample holder sliding inside the sample chamber, said sample chamber comprising a cryostatic inner chamber (14), arranged for receiving the sample holder sliding inside the inner chamber, and two warm intermediate chambers. The cryostat comprises sliding seals allowing sliding the sample holder while being leak-tight to fluids.

The invention also relates to a DNP device (10) or a NMR system (11) comprising said cryostat (8), an a process implemented by said cryostat (8), DNP device (10) or NMR system (11).

## Description

### Technical field

The present invention relates to a cryostat.

The invention also relates to a DNP device or a NMR system comprising said cryostat, and a process implemented by said cryostat or DNP device or NMR system.

### State of the Art

Dissolution dynamic nuclear polarization (dDNP) significantly enhances liquid-state NMR sensitivity, but existing methods face limitations in efficiently melting samples while maintaining hyperpolarization.

The inherently low sensitivity of nuclear magnetic resonance (NMR) experiments can be circumvented by means of dynamic nuclear polarization (DNP) methods.^{1,2} DNP relies on bringing nuclei (¹H, ¹³C...) in close presence of unpaired electrons, which in turn, by microwave irradiation, can transfer their high spin polarization to boost NMR signals by factors of 10² to 10⁴.³ It is often conducted in frozen, solid conditions to guarantee an effective coupling between the polarization agent and nuclei of interest.⁴ In this state, a variety of DNP mechanisms (e.g. solid effect, cross effect, and/or thermal mixing) is available to initially transfer polarization from electrons to nuclei and, afterward, spread this polarization uniformly across the sample with spin diffusion.⁵⁻⁹ This process is allowed by the dipolar interaction (kHz) between nuclei.^{10,11} Boosting polarization in solid conditions can be done in various ways. However, there is widespread interest in having access to the same hyperpolarized nuclei but solvated in solution. In this environment, isotropic molecular tumbling averages out dipolar interactions which makes fine structural features (Hz) accessible and observable with unprecedented sensitivity. Moreover, with the current democratization of benchtop NMR systems (Bruker F80, Magritek Spinsolve), which are more accessible but also less sensitive than high-field NMR, the need for liquid-state hyperpolarization becomes even more critical and desired.¹²

Already numerous strategies have been developed to achieve high spin polarization by DNP in the liquid-state.^{13,14} In general, they can be divided into two main classes. The first class of strategies performs both hyperpolarization and detection in solution state and relies on the Overhauser principle¹⁵. The second class counts on a hyperpolarization step conducted in frozen, solid conditions, and a detection step after the sample has undergone a solid-liquid phase transition.^{4,14} In both scenarios, the hyperpolarization and detection can either be separated, each in a dedicated polarizer and spectrometer, or be performed in situ, thus without physically moving the sample. All these diversities in hyperpolarization strategies gave rise to a plethora of existing DNP technologies capable of boosting the sensitivity of analytes in the liquid-state. Overhauser-flow DNP¹⁶, dissolution-DNP or dDNP⁴, bullet-DNP¹⁷, rapid-melt DNP¹⁸ and laser-melt DNP¹⁹ are examples and will be discussed further in the introduction.

Recently, another DNP strategy has been introduced with the goal of repeatedly enhancing liquid-state NMR signals, yet without dilution nor contamination of radicals in the measured solution to avoid any signal loss by unwanted paramagnetic relaxation.^{20,21} The principle of this idea is based on employing porous hyperpolarizing matrices with immobilized radicals on the material surface through which the analyte can be pushed as if being a heterogeneous packed-bed hyperpolarization reactor.²² This is equivalent to the Overhauser-flow DNP approach, even so instead of relying on liquid-state polarization transfer, the target solution impregnated in the pores is first frozen inside a compact 1 T benchtop DNP polarizer operating at 77 K, before eventually being melted and pushed out for detection in a dedicated NMR spectrometer. The freeze-melt cycle circumvents the main drawback intrinsic to Overhauser DNP: the limited target scope that is generally susceptible for hyperpolarization via cross-relaxation mechanisms. However, the process of repeatedly freezing and melting a heterogeneous packed-bed unit brings forward new technical requirements that will be tackled throughout this paper. Indeed, freezing and melting in the same cryostat, as it is done, for example in dDNP experiments, poses many technical issues, and raises problems of thermodynamical efficiency.

Until now, the 1 T benchtop DNP polarizer has been equipped with a double-wall vacuum-isolated glass cryostat capable of cooling down a static 4 mm OD quartz tubes to 77 K. A volume of 250 µL of batch sample can be hyperpolarized after irradiating it with microwaves at a frequency of 28 GHz via a WR-28 waveguide. The microwaves pass the transparent glass cryostat and further spread into an open brass cavity with a quality factor (Q) expected not to be significantly higher than one. The successful hyperpolarization of ¹H and ¹³C nuclei of acetate impregnated in the pores of HYPSO-5 has been shown, a mesoporous silica with TEMPOL radicals covalently attached to the surface.

Enhancement factors for ¹H and ¹³C reached almost 100 x the thermal equilibrium solid-state signal.²⁰ The presence of orthogonal ¹H and ¹³C radiofrequency (rf) coils resonating at respectively 42.7 MHz and 10.7 MHz allowed for successful implementation of a 1 millisecond cross-polarization (CP) step at 77 K from ¹H nuclei of water to ¹³C nuclei of the acetate analyte residing in the pores. This has been a crucial breakthrough for making use of the rapid ¹H polarization buildup rate (2 s⁻¹) in the pores at 1 T, while preventing the ¹³C magnetization from direct contact with the electrons to lead to longitudinal relaxation rates slower than 0.01 s⁻¹. But despite the DNP optimization, the current cryostat and sample holder designs do not give any prospect of rapidly freezing and melting the sample and are certainly not suited for the extraction of hyperpolarized solution afterward.

Generally, three types of cryostat designs are employed for cooling down sample cavities and/or detection cavities in DNP context. While the purpose for each is identical, namely improving the sensitivity of detection, cryostat designs follow either the principle of bath cryostats or continuous flow cryostats. Both cryogenic liquids or a closed-cycle refrigerator system can be used as a coolant source. The latter is typically referred to as the 'cryogen-free' approach. ^{27,28} Starting with dDNP, the principle of a bath cryostat is used.²⁵ The cryostat assembly is positioned inside the bore of a commercially available superconducting magnet, and via an independent probe head, the sample, the microwave components, and the rf coils are fully immersed in the cryogenic liquid (mainly helium). Note that in the case of permanent magnet devices, incorporating them inside the cold cryostat is also a possible configuration.²⁹ In both scenarios, thermal conduction to the ambient environment is minimized by a series of vacuum jackets towards the outside of the cryostat, made from stainless steel or copper with voids in between (< 10⁻⁷ mbar).^{30,31} Radiative heat losses are minimized by a series of radiation shields installed both in the vacuum jackets and on the probe head, again made from copper or stainless steel. Due to the size of the cryostat-probe assembly, fast and reversible sample evacuation is unrealistic using this design. Instead, dissolution/dilution of the sample with hot and pressurized solvent is used for detection in a separate liquid-state spectrometer unit.^{4,14} Yet, the recent bullet-DNP development made it possible to transport a plug of frozen and hyperpolarized sample inside an ultrahigh molecular weight polyethylene container from the bath cryostat to the liquid-state spectrometer.^{17,32} However, the presence of paramagnetic relaxation sinks still requires dilution of the sample once transported, making the strategy again destructive. In MAS-DNP systems, the hyperpolarization and detection step does not require to be separated since both are performed in solid-state without requiring a phase transition. Here, the principle of continuous-flow cryostats is used to supply a continuous stream of cold cryogenic gas (nitrogen or helium) to the DNP-NMR cavity. Similar to the dDNP case, both the sample (contained in a rotor made from a ¹H-free, microwave and rf-transparent material) together with the microwave and rf parts, are encapsulated in a vacuum isolated cryostat, with isolated in- and outputs for the coolant gas.^{23,24,27} A variety of strategies for effective cooling and transfer line isolation have been developed over the years^{23,24,26,27,33,34}. One of them incorporated an in-situ temperature-jump step for integrating a liquid-state detection inside the MAS-DNP cryostat. A CO₂ laser transmitting 10.6 µm IR light via a multimode hollow optic fibre was used to melt the sample as rapidly as possible so as to minimize signal loss due to paramagnetic polarizing agents.^{19,35} An analogue approach, but with separate cooling and heating steps performed inside the bore of a liquid-state spectrometer, was afterward developed and termed rapid-melt DNP.¹⁸

The goal of the invention is to present a cryostat:
- more suited for rapidly freezing and/or melting a sample, and/or
- more suited for the extraction of a hyperpolarized solution afterward, and/or
- having a higher efficiently in melting samples while maintaining a hyperpolarization.

### Summary of the Invention

An aspect of the invention concerns a cryostat comprising a sample chamber arranged for receiving a sample holder sliding inside the sample chamber, said sample chamber comprising :
- an inner chamber, arranged for receiving the sample holder sliding inside the inner chamber between a first opening and a second opening of the inner chamber,
- a first intermediate chamber arranged for receiving the sample holder sliding inside the first intermediate chamber between the first opening of the inner chamber and a first exit of the cryostat,
- a second intermediate chamber arranged for receiving the sample holder sliding inside the second intermediate chamber between the second opening of the inner chamber and a second exit of the cryostat,

the cryostat comprising means for cooling the inner chamber to a cryogenic temperature below 120 K,
characterized in that :
   the cryostat comprises means for maintaining the first intermediate chamber at a first warm temperature above the cryogenic temperature,
   the cryostat comprises means for maintaining the second intermediate chamber at a second warm temperature above the cryogenic temperature,
   the cryostat comprises a first inner sliding seal between the inner chamber and the first intermediate chamber, said first inner sliding seal being arranged for allowing sliding the sample holder through the first inner sliding seal while being leak-tight to fluids contained in the inner chamber and in the first intermediate chamber,
   the cryostat comprises a second inner sliding seal between the inner chamber and the second intermediate chamber, said second inner sliding seal being arranged for allowing sliding the sample holder through the second inner sliding seal while being leak-tight to fluids contained in the inner chamber and in the second intermediate chamber.

The cryostat can comprise:
- at the first exit, a first outside sliding seal, said first outside sliding seal being arranged for allowing sliding the sample holder through the first outside sliding seal while being leak-tight to fluids contained in the first intermediate chamber and outside the first intermediate chamber, and/or

- at the second exit, a second outside sliding seal, said second outside sliding seal being arranged for allowing sliding the sample holder through the second outside sliding seal while being leak-tight to fluids contained in the second intermediate chamber and outside the second intermediate chamber.

The inner chamber can be delimited by inner chamber walls of which a polarizing part is transmissive to microwaves and/or radio frequencies, preferably having an intensity transmission coefficient of at least 50% for at least one frequency between 1 GHz and 300 GHz, and preferably for at least one frequency between 1 MHz and 300 MHz.

The cryostat can comprise:
- a vacuum chamber, surrounding all the inner chamber, the first inner sliding seal, at least a part of the first intermediate chamber, the second inner sliding seal and at least a part of the second intermediate chamber,
- means for creating an isolating vacuum inside the vacuum chamber.

The vacuum chamber can be delimited by vacuum chamber walls of which a polarizing part is transmissive to microwaves and/or radio frequencies, preferably having an intensity transmission coefficient of at least 50% for at least one frequency between 1 GHz and 300 GHz, and preferably for at least one frequency between 1 MHz and 300 MHz.

The means for cooling the inner chamber can comprise means for injecting a cryogenic fluid inside the inner chamber.

The means for maintaining the first intermediate chamber at a temperature above the cryogenic temperature can comprise means for injecting a warm gas at the first warm temperature inside the first intermediate chamber.

The means for maintaining the second intermediate chamber at a temperature above the cryogenic temperature can comprise means for injecting a warm gas at the second warm temperature inside the second intermediate chamber.

The cryostat according to the invention can further comprise the sample holder inside the sample chamber.

The sample holder can comprise a conduit:
- arranged for containing a solvent with one or more molecules to be examined,
- in which is enclosed a (preferably porous and/or solid) polarization agent containing (preferably immobilized) paramagnetic species,
   the conduit being arranged to allow the solvent and the one or more molecules to be examined to flow inside the conduit along a fluid circuit so that the one or more molecules to be examined can go in and out of the polarization agent.

At least the portion of the conduit surrounding the polarization agent can be made from a material transmissive to microwaves and/or radio frequencies, preferably having an intensity transmission coefficient of at least 50 for at least one frequency between 1 GHz and 300 GHz, and preferably for at least one frequency between 1 MHz and 300 MHz.

The cryostat can comprise moving means arranged for moving the sample holder inside the sample chamber so that the sample holder can have at least the following positions:
- an inner position in which the polarization agent is located inside the inner chamber,
- at least one position among:
   o a first intermediate position in which the polarization agent is located inside the first intermediate chamber,
   o a second intermediate position in which the polarization agent is located inside the second intermediate chamber.

The cryostat according to the invention can further comprise a heating chamber in communication with the second intermediate chamber, the moving means being arranged for moving the sample holder so that the sample holder can have a heating position in which the polarization agent is located inside the heating chamber, the cryostat comprising heating means arranged for heating at least a part of the sample holder inside the heating chamber.

The conduit can comprise:
- At least one among :
   ∘ A first set comprising:
      ▪ upstream the portion of the fluid circuit including the polarization agent, an upstream capillary arranged for allowing the solvent and the one or more molecules to be examined to flow inside the conduit along the fluid circuit before reaching the polarization agent,
      ▪ an upstream conduit vacuum chamber surrounding the upstream capillary, so that when the sample holder is in its second intermediate position, the upstream capillary is isolated from the inner chamber by the upstream conduit vacuum chamber,
      ▪ means for creating an isolating vacuum inside upstream conduit vacuum chamber ,
   ∘ a second set comprising:
      ▪ downstream the portion of the fluid circuit including the polarization agent, a downstream capillary arranged for allowing the solvent and the one or more molecules to be examined to flow inside the conduit along the fluid circuit after leaving the polarization agent,
      ▪ a downstream conduit vacuum chamber surrounding the downstream capillary, so that when the sample holder is in its first intermediate position, the downstream capillary is isolated from the inner chamber by the downstream conduit vacuum chamber,
      ▪ means for creating an isolating vacuum inside downstream conduit vacuum chamber ,

An other aspect of the invention concerns a dynamic nuclear polarization device comprising the cryostat according to the invention, said dynamic nuclear polarization device further comprising :
- means for subjecting the first intermediate chamber, and/or the second intermediate chamber to a magnetic field greater than 50mT, and/or
- means for subjecting the inner chamber to a magnetic field greater than 100mT, and/or
- means for subjecting the inner chamber to microwaves having at least one frequency between 1 GHz and 300 GHz, and/or
- means for subjecting the inner chamber to radio frequencies having at least one frequency between 1 MHz and 300 MHz.

Another aspect of the invention concerns a nuclear magnetic resonance system comprising the dynamic nuclear polarization device according to the invention, characterized in that the nuclear magnetic resonance system comprises a magnetic resonance examination device, the fluid circuit extending outside the sample chamber and through the magnetic resonance examination device, the fluid circuit being a flow-through fluid circuit arranged for producing a portion of hyperpolarized liquid in the sample chamber while using in the magnetic resonance examination device another portion of hyperpolarized liquid previously produced in the sample chamber.
An other aspect of the invention concerns a process implemented in:
- a device according to the invention, and comprising a dissolution dynamic nuclear polarization or a cross polarization step inside the sample chamber for producing a hyperpolarized liquid, or
- a system according to the invention, and comprising:
   ∘ a dissolution dynamic nuclear polarization or a cross polarization step inside the sample chamber for producing a hyperpolarized liquid and
   ∘ using or analyzing in the magnetic resonance examination device another portion of hyperpolarized liquid previously produced in the sample chamber.

### Detailed description of the figures and of realization modes of the invention

Other advantages and characteristics of the invention will appear upon examination of the detailed description of embodiments which are in no way limitative, and of the appended drawings in which:
- Figure 1 is a detailed exploded view of the described embodiment of the cryostat 8 according to the invention, detailing the position of various (but not all, in particular not the heating chamber 37) components of cryostat 8,
- Figure 2 is a schematic cross sectioned side view of cryostat 8 (without some parts, in particular without the heating chamber 37),
- Figure 3 is a schematic perspective view of cryostat 8 (without some parts, in particular without the heating chamber 37),
- Figure 4 illustrates different views (perspective view, then side view, then cross sectioned side view) of part 1a of cryostat 8 also shown in figure 1,
- Figure 5 illustrates different views (perspective view, then side view, then cross sectioned side view) of part 2a of cryostat 8 also shown in figure 1,
- Figure 6 illustrates different views (perspective view, then side view, then cross sectioned side view) of part 3a of cryostat 8 also shown in figure 1,
- Figure 7 illustrates different views (perspective view, then side view, then cross sectioned side view) of:
   - part 1b (that is the combination of 1b-1 and 1b-2) of cryostat 8 also shown in figure 1 (on part a) of figure 7),
   - part 1b-1 of cryostat 8 also shown in figure 1 (on part b) of figure 7),
   - part 1b-2 of cryostat 8 also shown in figure 1 (on part c) of figure 7),
- Figure 8 illustrates different views (perspective view, then side view, then cross sectioned side view) of part 2b of cryostat 8 also shown in figure 1, more precisely:
   - part 2b-1 of cryostat 8 also shown in figure 1 (on part a) of figure 8),
   - part 2b-2 of cryostat 8 also shown in figure 1 (on part b) of figure 8),
- Figure 9 illustrates different views (perspective view, then side view, then cross sectioned side view) of part 3b of cryostat 8 also shown in figure 1,
- Figure 10 illustrates different views (perspective view, then side view, then cross sectioned side view) of part 4b of cryostat 8 also shown in figure 1,
   - part 4b-1 of cryostat 8 also shown in figure 1 (on part a) of figure 8),
   - part 4b-2 of cryostat 8 also shown in figure 1 (on part b) of figure 8),
- Figure 11 is face view (part a) and a cross sectioned side view (part b) of sample holder 13,
- Figure 12 is a face view (part a, without the heating chamber 37) and a cross sectioned side view (part b, with the heating chamber 37) of the sample holder 13 inside the cryostat 8, the sample holder 13 being in its inner position,
- Figure 13 is a cross sectioned side view (with the heating chamber 37) of the sample holder 13 inside the cryostat 8, the sample holder 13 being in its second intermediate position,
- Figure 14 is a cross sectioned side view (with the heating chamber 37) of the sample holder 13 inside the cryostat 8, the sample holder 13 being in its heating position,
- Figure 15 is a cross sectioned side view (without the heating chamber 37) of the described embodiment of DNP device 10 according to the invention comprising the cryostat 8, and
- Figure 16 is a schematic view of the described embodiment of NMR system 11 according to the invention comprising the DNP device 10.

These embodiments being in no way limitative, we can consider variants of the invention including only a selection of characteristics subsequently described or illustrated, isolated from other described or illustrated characteristics (even if this selection is taken from a sentence containing these other characteristics), if this selection of characteristics is sufficient to give a technical advantage or to distinguish the invention over the state of the art. This selection includes at least one characteristic, preferably a functional characteristic without structural details, or with only a part of the structural details if that part is sufficient to give a technical advantage or to distinguish the invention over the state of the art.

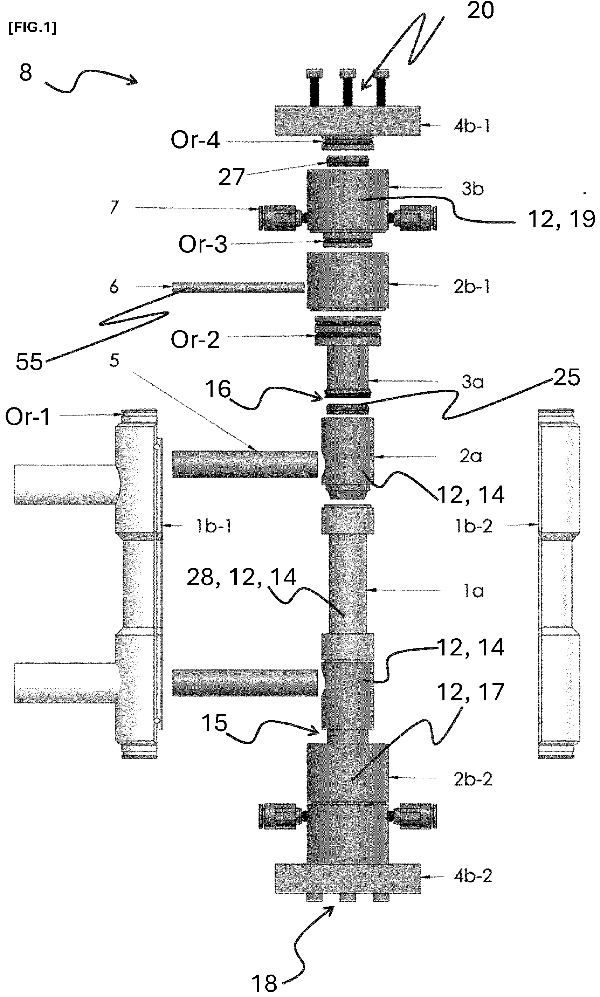

We are now going to describe, in reference to figures 1 to 16, a first embodiment of a cryostat 8 according to the invention in particular in a first embodiment of a DNP device 10 according to the invention or in a first embodiment of a NMR system 11 according to the invention.

The cryostat 8 (see in particular figures 1, 2 and 3) comprises a sample chamber 12 arranged for receiving a sample holder 13 sliding inside the sample chamber 12.

The sample chamber 12 comprises :
- an inner chamber 14 (also called cryogenic chamber 14), arranged for receiving the sample holder 13 sliding inside the inner chamber 14 between a first opening 15 and a second opening 16 of the inner chamber 14, and
- a first intermediate chamber 17 arranged for receiving the sample holder 13 sliding inside the first intermediate chamber 17 between the first opening 15 of the inner chamber 14 and a first exit 18 of the cryostat,
- a second intermediate chamber 19 arranged for receiving the sample holder 13 sliding inside the second intermediate chamber 19 between the second opening 16 of the inner chamber 14 and a second exit 20 of the cryostat 8.

The cryostat 8 comprises means for cooling 21 the inner chamber 14 to a cryogenic temperature below 120 K (typically above 3 K (preferably above 30 K, preferably above 75 K, in particular to avoid cooling any permanent magnets nearby) and/or below 100 K).

The cryostat 8 comprises means for maintaining 22 the first intermediate chamber 17 at a first warm temperature above the cryogenic temperature.

The cryostat 8 comprises means for maintaining 23 the second intermediate chamber 19 at a second warm temperature above the cryogenic temperature.

The first warm temperature is preferably equal to the second warm temperature.

The first warm temperature and/or the second warm temperature is above 200 K, preferably above 273.15 K, most preferably above 283,15 K.

The first warm temperature and/or the second warm temperature is below 373.15 K, most preferably below 323.15 K, most preferably below 303,15 K.

The cryostat 8 comprises a first inner sliding seal 24 between the inner chamber 14 and the first intermediate chamber 17 , said first inner sliding seal 24 being arranged for allowing sliding the sample holder 13 through the first inner sliding seal 24 while being leak-tight to fluids contained in the inner chamber 14 and in the first intermediate chamber 17, preferably for any difference of pressure between the two sides of the first inner sliding seal 24 (that is between the inner chamber 14 and the first intermediate chamber 17) below 1 bar, the difference of pressure between the two sides of the first inner sliding seal 24 being typically less than 500 mbar, preferably less than 50 mbar.

The cryostat 8 comprises a second inner sliding seal 25 between the inner chamber 14 and the second intermediate chamber 19 , said second inner sliding seal 25 being arranged for allowing sliding the sample holder 13 through the second inner sliding seal 25 while being leak-tight to fluids contained in the inner chamber 14 and in the second intermediate chamber 19, preferably for any difference of pressure between the two sides of the second inner sliding seal 25 (that is between the inner chamber 14 and the second intermediate chamber 19) below 1 bar, the difference of pressure between the two sides of the second inner sliding seal 25 being typically less than 500 mbar, preferably less than 50 mbar.

The cryostat 8 comprises, at the first exit 18, a first outside sliding seal 26, said first outside sliding seal 26 being arranged for allowing sliding the sample holder 13 through the first outside sliding seal 26 while being leak-tight to fluids contained in the first intermediate chamber 17 and outside the first intermediate chamber, preferably for any difference of pressure between the two sides of the first outside sliding seal 26 (that is between the first intermediate chamber 17 and outside the first intermediate chamber) below 1 bar, the difference of pressure between the two sides of the first outside sliding seal 26 being typically less than 500 mbar, preferably less than 50 mbar.

The cryostat 8 comprises, at the second exit 20, a second outside sliding seal 27, said second outside sliding seal 27 being arranged for allowing sliding the sample holder 13 through the second outside sliding seal 27 while being leak-tight to fluids contained:
- in the second intermediate chamber 19 and
- outside the second intermediate chamber (in particular inside the heating chamber 37 described below),
preferably for any difference of pressure between the two sides of the second outside sliding seal 27 (that is between:
- the second intermediate chamber 19 and
- outside the second intermediate chamber, in particular inside the heating chamber 37 described below) below 1 bar, the difference of pressure between the two sides of the second outside sliding seal 27 being typically less than 500 mbar, preferably less than 50 mbar.

By "leak-tight to fluids" for each seal 24, 25, 26 or 27, it is preferably meant a leak through this seal less than 1 mbar per liter per second, more preferably less than 10⁻³ mbar per liter per second, more preferably less than 10⁻⁵ mbar per liter per second.

Each seal 24, 25, 26, 27 is a fluoropolymer seal or a PTFE (Polytetrafluoroethylene) seal.

Each seal 24, 25, 26, 27 is a dynamic seal. That means that each seal is leak-tight to fluids as previously described:
- even while the sample holder 13 is sliding through this seal (typically at a speed lower than 10 meters per second, preferably lower than 5 meters per second, preferably lower than 1 meter per second)
- for all temperatures comprise between the cryogenic temperature and the highest value among the first warm temperature and the second warm temperature, preferably for all temperatures comprise between 75 K and 303.15 K, preferably for all temperatures comprise between 30 K and 323.15 K, preferably for all temperatures comprise between 3 K and 373.15 K,

Each seal 24, 25, 26, 27 is preferably a spring-energized seal.

Each seal 24, 25, 26, 27 is preferably a elastomer-energized seal.

Each seal 24, 25, 26, 27 typically comprises a toric seal, preferably made of or comprising PTFE, inside which is a toric spring.

Each seal 24, 25, 26, 27 is preferably a "DynSeal" model or "Turcon^{®} Variseal^{®}" model by Trelleborg or equivalent model. Each seal 24, 25, 26, 27 is preferably a seal made of Turcon^{®} MC1 or Turcon^{®} MC2 or equivalent, and is preferably made of PTFE-based materials and used as a spring and elastomer-energized seal.

The inner chamber 14 is delimited by inner chamber walls of which a polarizing part 28 is transmissive to microwaves and/or radio frequencies, having an intensity transmission coefficient of at least 50%, preferably at least 80%, for:
- at least one frequency (preferably all frequencies) between 1 GHz and 300 GHz, as this frequency range is desired for polarizing, and
- preferably for at least one frequency (preferably all frequencies) between 1 MHz and 300 MHz, as this frequency range is optional and used in particular in cases of cross polarization or to observe or quantify the absolute level enhancement of the nuclear spin polarization through NMR.

The cryostat 8 furthermore comprises:
- a vacuum chamber 29, surrounding all the inner chamber 14, the first inner sliding seal 24, at least a part of the first intermediate chamber 17, the second inner sliding seal 25 and at least a part of the second intermediate chamber 19,
- means 30 (pump) for creating an isolating vacuum inside the vacuum chamber 29, this vacuum having a pressure typically below 100 µbars or even below 10 µbars.

The vacuum chamber 29 is delimited by vacuum chamber walls of which a polarizing part 31 (preferably surrounding the polarizing part 28 of the inner chamber walls) is transmissive to microwaves and/or radio frequencies, preferably having an intensity transmission coefficient of at least 50%, preferably at least 80%, for:
- at least one frequency (preferably all frequencies) between 1 GHz and 300 GHz, as this frequency range is desired for polarizing, and
- preferably for at least one frequency (preferably all frequencies) between 1 MHz and 300 MHz, as this frequency range is optional and used in particular in cases of cross polarization or to observe or quantify the absolute level enhancement of the nuclear spin polarization through NMR.

The means 21 for cooling the inner chamber comprise means for injecting a cryogenic fluid inside the inner chamber 14. This injected fluid is typically a liquid or a gaz, for example liquid Nitrogen above 77.36 K (for example around 100 K) or liquid Helium below 4.13 K or gaseous Helium above 4.13 K.

The means 22 for maintaining the first intermediate chamber 17 at a temperature above the cryogenic temperature comprise means for injecting a warm gas at the first warm temperature inside the first intermediate chamber 17, preferably a neutral gas, preferably nitrogen, argon and/or helium.

The means 23 for maintaining the second intermediate chamber 19 at a temperature above the cryogenic temperature comprise means for injecting a warm gas at the second warm temperature inside the second intermediate chamber 19, preferably a neutral gas, preferably nitrogen, argon and/or helium.

The cryostat 8 comprises the sample holder 13 inside the sample chamber 12.

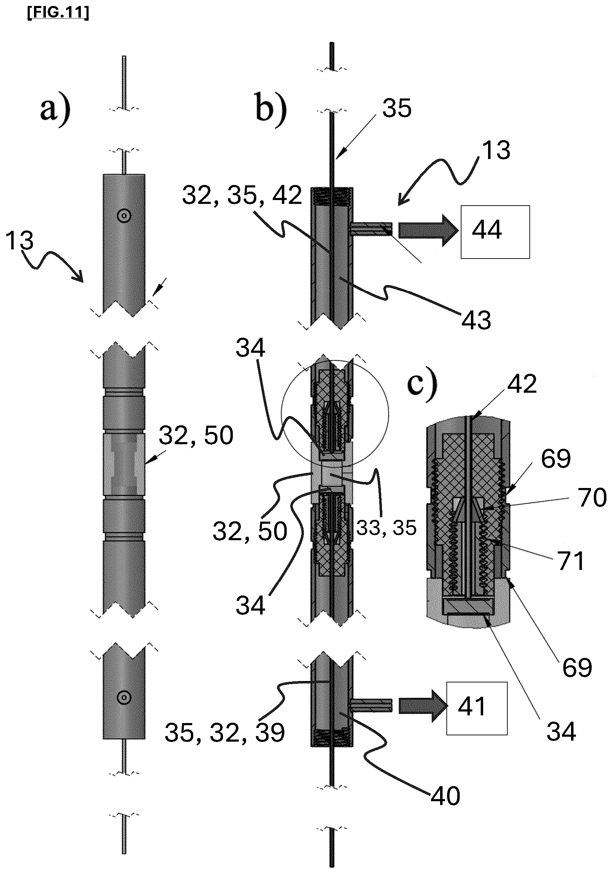

The sample holder 13 (Figure 11) comprises a conduit 32:
- arranged for containing a solvent with one or more molecules to be examined,
- in which is enclosed a porous, solid polarization agent 33 containing immobilized paramagnetic species.

The conduit 32 comprises means for keeping the agent 33 immobile within the conduit 32.

The agent 33 can:
- be a single-piece porous solid or
- a powder placed between two filters 34, the filters 34 maintaining the powder between the two filters.

The agent 33 typically comprises a mono or poly radical, preferably a bi radical, preferably a free radical (such as a nitroxide or trityl or BDPA ((α,γ-bisphenylene-β-phenylallyl-benzolate)), etc.), preferably at a concentration of at least 1µmol/g, and/or preferably inside a porous material such as a polymer (such as Epoxy, polystyrene, etc. ) or silica, etc.

The filters 34:
- are preferably made of a non magnetic material, and/or
- are typically made of PEEK, PTFE, stainless steel or brass.

The conduit 32 is arranged to allow the solvent and the one or more molecules to be examined to flow inside the conduit 32 along a fluid circuit 35 so that the one or more molecules to be examined can go in and out of the polarization agent 33.

The portion 50 of the conduit 32 surrounding the polarization agent 33 is made from a material transmissive to microwaves and/or radio frequencies, having an intensity transmission coefficient of at least 50%, preferably at least 80%, for:
- at least one frequency (preferably all frequencies) between 1 GHz and 300 GHz, as this frequency range is desired for polarizing, and
- preferably for at least one frequency (preferably all frequencies) between 1 MHz and 300 MHz, as this frequency range is optional and used in particular in cases of cross polarization or to observe or quantify the absolute level enhancement of the nuclear spin polarization through NMR.

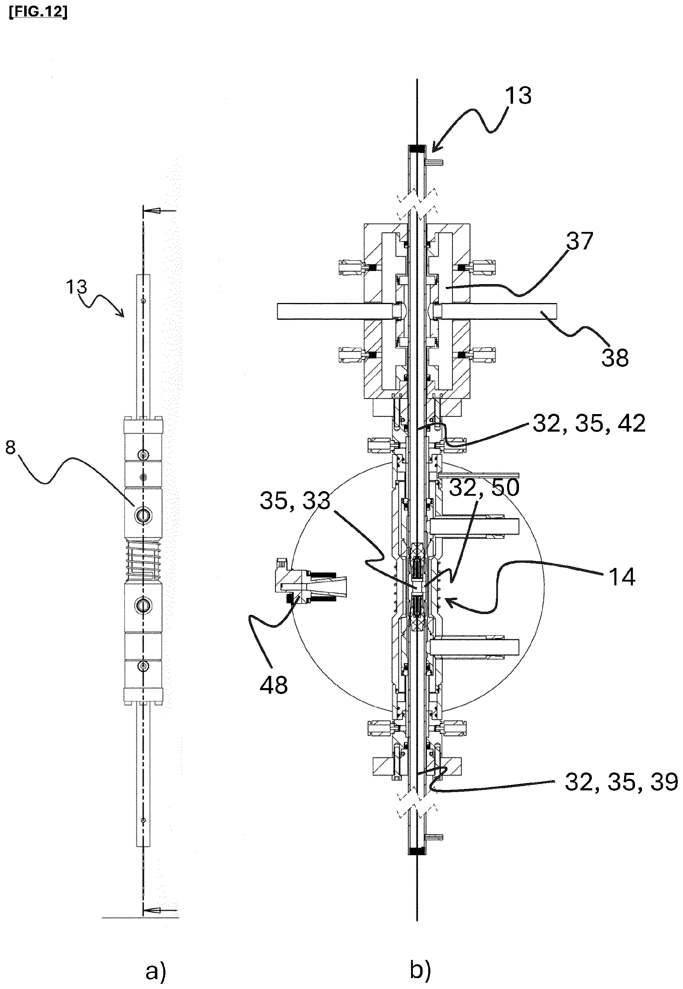

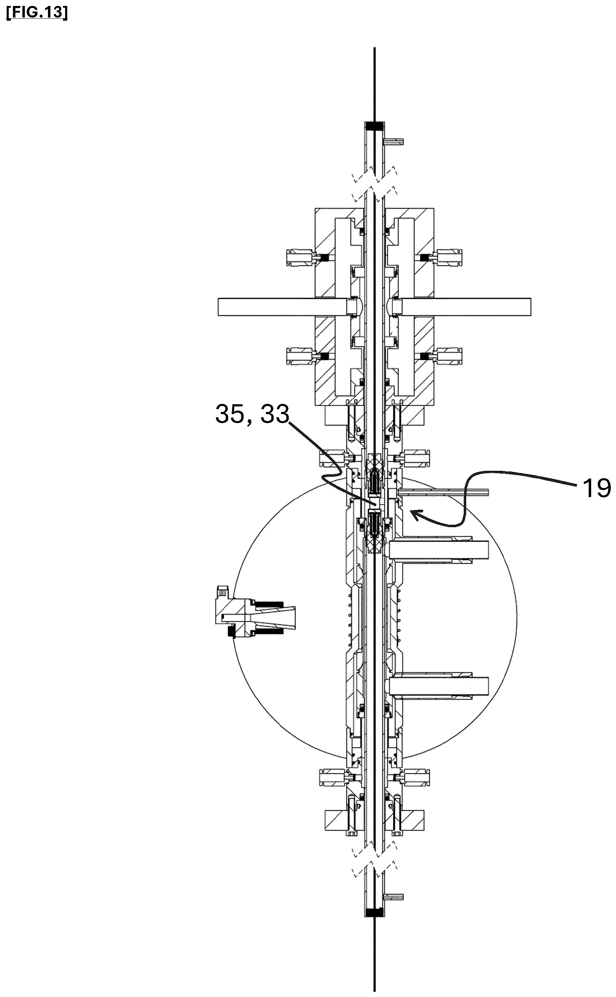

The cryostat 8 comprises moving means 36 (not illustrated in the figures, such like a motor) arranged for moving the sample holder 13 inside the sample chamber 12 so that the sample holder 13 can have at least the following positions:
- an inner position (illustrated in Figure 12) in which the polarization agent 33 is located inside the inner chamber 14,
- optionally a first intermediate position (not shown) in which the porous, solid polarization agent 33 is located inside the first intermediate chamber 17,
- a second intermediate position (illustrated in Figure 13) in which the polarization agent 33 is located inside the second intermediate chamber 19.

In the inner position, the agent 33 is surrounded by the polarizing 28 part of the inner chamber walls of the inner chamber 14.

In the inner position, the agent 33 is surrounded by the polarizing 31 part of the walls of the vacuum chamber 29.

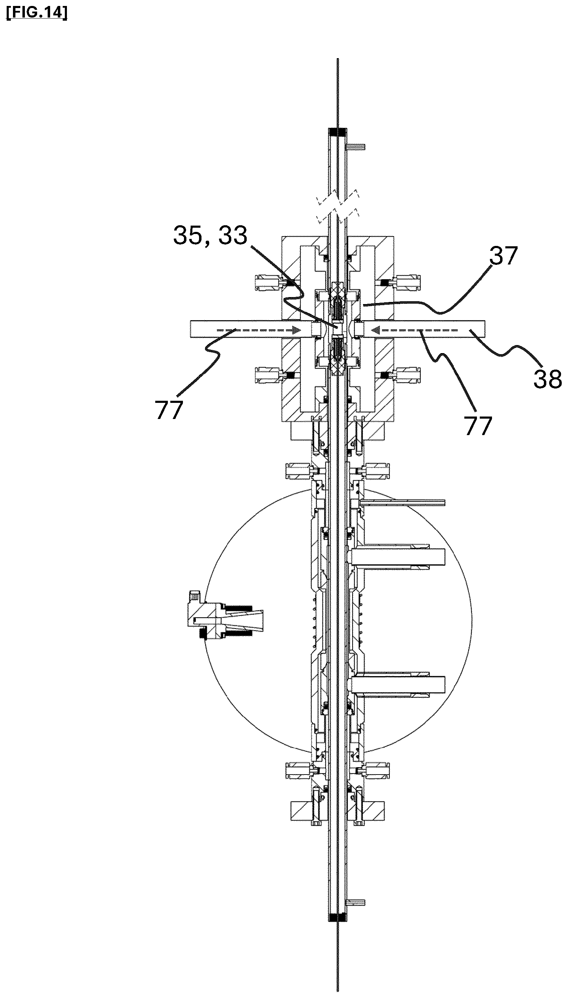

The cryostat 8 further comprises a heating chamber 37 in communication, through the second outside sliding seal 27, with the second intermediate chamber 19, the moving means 26 being arranged for moving the sample holder 13 so that the sample holder 13 can have a heating position (illustrated in Figure 14) in which the polarization agent 33 is located inside the heating chamber 37.

The cryostat 8 comprises heating means 38 arranged for heating (preferably by radiation) at least a part (comprising agent 33) of the sample holder 13 inside the heating chamber 37 when the sample holder is in its heating position:
- preferably up to a temperature above 273.15 K, most preferably above 283,15 K, and/or
- preferably to a temperature below 353.15 K, most preferably below 323,15 K, most preferably below 293,15 K.

The heating means 38 typically comprise:
- means for generating a flow of hot (preferably above 100, 200 or 400°C) gas in contact with portion 50 of the conduit 32 surrounding the polarization agent 33, or
- means for bringing a hot solid (preferably above 100, 200 or 400°C) into contact with portion 50 of the conduit 32 surrounding the polarization agent 33, or
- means for emitting or conducting at least one laser beam 77 (typical power of 10 W to 1000W and wavelength of 780 nm to 10µm, preferably around 1µm) towards the agent 33 when the sample holder 13 is in its heating position.

In other variants, means 38 can also comprise infrared, RadioFrequency or microwave means.

The conduit 32 comprises:
- A first set comprising:
   ∘ upstream the portion of the fluid circuit 35 including the polarization agent 33, an upstream capillary 39 arranged for allowing the solvent and the one or more molecules to be examined to flow inside the conduit 32 along the fluid circuit 35 before reaching the polarization agent 33,
   ∘ an upstream conduit vacuum chamber 40 (Figure 11) surrounding the upstream capillary 39, so that:
      ▪ when the sample holder 13 is in its second intermediate position (illustrated in Figure 13), the upstream capillary 39 is isolated from the inner chamber 14 by the upstream conduit vacuum chamber 40, in order to avoid freezing of the upstream capillary 39 and its contents,
      ▪ when the sample holder 13 is in its heating position (illustrated in Figure 14), the upstream capillary 39 is isolated from the inner chamber 14 by the upstream conduit vacuum chamber 40, in order to avoid freezing of the upstream capillary 39 and its contents,
   ∘ means (pump) 41 for creating an isolating vacuum inside the upstream conduit vacuum chamber 40, this vacuum having a pressure typically below 100 µbars or even below 10 µbars,
- a second set comprising:
   ∘ downstream the portion of the fluid circuit 35 including the polarization agent 33, a downstream capillary 42 arranged for allowing the solvent and the one or more molecules to be examined to flow inside the conduit 32 along the fluid circuit 35 after leaving the polarization agent 33,
   ∘ a downstream conduit vacuum chamber 43 (Figure 11) surrounding the downstream capillary 42, so that when the sample holder 13 is in its first intermediate position, the downstream capillary 42 is isolated from the inner chamber 14 by the downstream conduit vacuum chamber 43, in order to avoid freezing of the downstream capillary 42 and its contents,
   ∘ means (pump) 44 for creating an isolating vacuum inside downstream conduit vacuum chamber 43, this vacuum having a pressure typically below 100 µbars or even below 10 µbars.

In a variant, in which means 41 and 44 can be not present, and chambers 40 and/or 43 can be replaced of filled by an insulating material (such as polystyrene).

Fig. 1 is a detailed exploded view of the cryostat 8 detailing the position of the various components, including the numbering of various components and the different chambers it comprises. We are now going to describe pieces 1a, 1b-1, 1b-2, 2a, 2b-1, 2b-2, 3a, 3b, 4b-1, 4b-2, 5, 6, 7 of the cryostat 8. The cryostat 8 is made of eleven different machined parts and two 3D printed resin parts, symmetric from the center, with numbering of these parts starting from '1' for the center to '4' for the end part. For the inner pieces' labels, a 'a' letter is added to their number ('1a' to '3a'). It is a 'b' instead ('1b' to '4b') for the outside ones. '1b-1' and '1b-2' are the two 3D printed pieces that close the external center structure of the cryostat 8. A '-1' ad '-2 are added to their respective label as they are not symmetric. The same convention is used for '2b-1' and '2b-2', and '4b-1' and '4b-2'. '2b-1' has, in plus a little hole added for soldering the vacuum connection tube 55 of the vacuum chamber 29. '4b-1' and '4b-2' differ in the M6 holes: the first ones are through holes, unlike the latter, which are threaded. '5' to '7' are commercial pieces added to the design. '5' and '6' are commercial stainless-steel tubes. '5' tubes connect the cryogenic chamber 14 with the liquid nitrogen transfer system and '6' the vacuum chamber 29 with the vacuum pump 30. '7' is a Legris LF3000 quick-connect adaptor for the gas flows inside the nitrogen gas chamber 19. Each seal 24, 25, 26 and 27 is a Trelleborg dynamic seal used for leak-tight translation of the sample holder 13, delimiting each of the three different chambers 17, 14, 19. Cryostat 8 also comprises four different types of Nitrile Rubber O-rings, labeled from 'Or-1' to 'Or-4'.

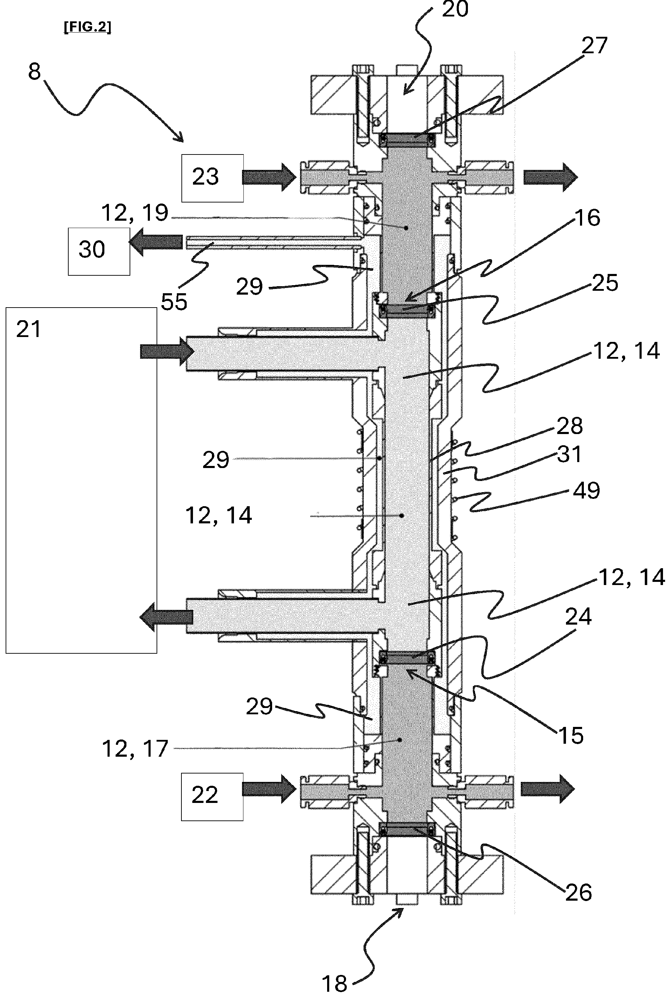

Fig. 2 is a cross-section of the assembled cryostat 8.

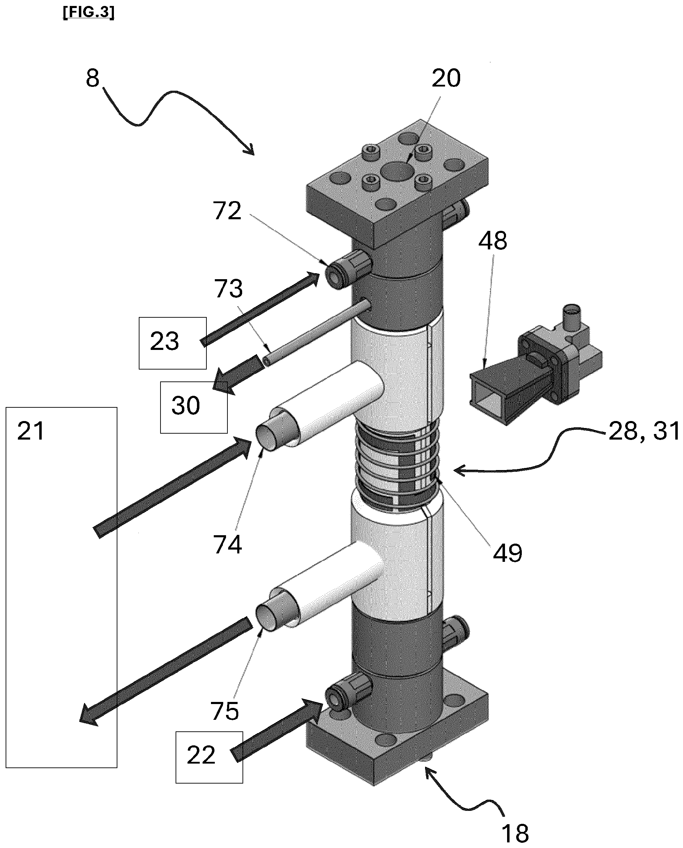

In this specific embodiment, the overall cryostat 8 measures 22 cm in height and 28 mm in diameter (see picture in Fig. 3 and detailed overview in Fig. 2). The cryostat 8 can be placed in the 1 T permanent magnet 46, 47 operating at room temperature while the inner chamber 14 of the cryostat 8 is operating at 77 K. The new design encompasses a central cryogenic double wall corresponding to parts '1a', '1b-1' and '1b-2', ensuring transparency to both microwaves for DNP and radio-frequency waves for CP-assisted DNP, and connected to parts '2a', '3a', '2b-1', and '2b-2' which allows to both hold the outer chamber 29 under vacuum in order to thermally isolates the 77 K inner chamber 14 of the cryostat 8 from the 300 K magnet environment, therefore minimizing the risk of magnetic field drift. Two cryogenic sliding seals 24, 25 enable sliding the sample holder 13 in the inner cryostat chamber 14, while being leak-tight to liquid nitrogen. Two additional intermediate chambers 17, 19 at the top and bottom, in parts '3a' and '3b', are filled with ambient dry nitrogen gas to eliminate moisture and mitigate ice formation that could disrupt the sample holder's translation to the dedicated melting unit 37 (not shown on almost all the figures but shown only on figures 12, 13 and 14) operating at far higher temperatures. Two additional dynamic seals 26, 27 placed between parts '3b' and '4b' ensure leak-tight interfaces while translating the sample holder 13.

In figure 3:
- reference 72 is a nitrogen gas quick connect connection,
- reference 73 is a vacuum connection tube,
- reference 74 is a nitrogen liquid input tube,
- reference 75 is a nitrogen liquid output tube.

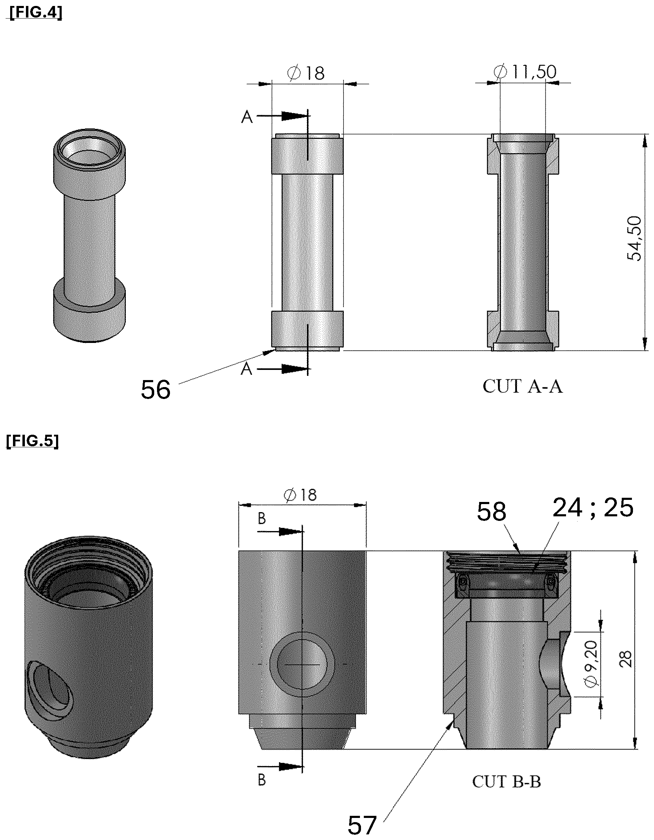

The materials were carefully selected according to their thermal conductivity, compatibility with low temperature regimes, machinability, non-magnetic properties, etc. Some of the most important criteria are summarized in below Table 1. To address all the cryostat's constraints, a combination of PEEK, 316L stainless steel, and aluminum pieces machined, and 3D-printed rigid 4000 resin from Formlabs is used. A detailed overview of the cryostat's parts with their numbering is shown in Fig. 1, while Figures 4 to 10 give more detailed views of all the different parts.

**Table 1. Summary of some of the most important properties of the materials used in the cryostat 8. Stainless-steel data for thermal conductivity are extracted from Jack W. Ekin's book 'Experimental Techniques for low-temperature Measurements' page 57930 and for thermal contraction from Bradley et Radebaugh page 1039. Polyetheretherketone (PEEK) thermal conductivity data were reported by Rule et Sparks, 1989, p. 2840 , and thermal contraction by Wang et al., 202441, p. 15. Notes: Austenitic stainless steel 304L has very close properties to 316L and can also be used as it is, in addition, less expensive.**

| | Thermal conductivit y at 300K (W.m⁻¹.K⁻¹) | Thermal conductivity at 77K (W.m⁻¹.K⁻¹) | Compatibility with low temperatures | Non-magnetic | Soldering | Epoxy gluing | Silicon | Thermal contraction ΔL/L at 77 K (%) |
|---|---|---|---|---|---|---|---|---|
| Stainless Steel 316L | 15 | 7,9 | YES | YES | YES | YES | YES | 0,28 |
| PEEK | 0.27 | 0.15 | YES | YES | YES | YES | YES | 0,8 |
| Formslab Rigid 4000 Resin | Not found | Not found | NO | YES | NO | YES | YES | Not found |

Fig. 4 is an overview of the '1a' PEEK part. This piece machined in Polyetheretherketone (PEEK) is the center of the cryostat 8 filled with liquid nitrogen and where the sample (i.e. the solvent with one or more molecules to be examined) is frozen. It is mostly transparent to radio frequencies and microwaves, a requirement for performing the DNP process. The piece is 54,5 mm high, has an 18 mm Outside Diameter (OD) at its largest sections, and an 11,5 mm Internal Diameter (ID) to have enough liquid nitrogen volume flowing around the sample. '2a' stainless-steel parts fit into the top and bottom inside a chamfered hole, and a groove 56 (groove for silicone Caf1-100) was designed to apply the high-performance silicone CAF1-100 and make the sealing. In addition, as PEEK shrinks more than stainless steel at 77 K, the play between the pieces is reduced at cryogenic temperature, reinforcing the leak-tight isolation.

Fig. 5 is an overview of the '2a' 316L austenitic stainless steel part. These two 28 mm high, 18 mm OD stainless-steel parts delimit the inner cryogenic chamber 14 of the cryostat 8 and connect it to the liquid nitrogen transfer system 21 with 9mm commercial stainless-steel tubes '6'. These tubes are soldered inside their 9,2 mm central holes. '2a' chamfered bottom fits into '1a' and the top hole is threaded (threated section 58) to screw '3a' inside. The top isolation is made with 10 mm Trelleborg dynamic seal 'DynSeal' 24 or 25 for the leak-tight translation of the sample holder 13 through the different chambers and with silicone put inside a groove 57 (groove for silicone Caf1-100) designed in '3a' to seal the cryogenic chamber from the vacuum chamber.

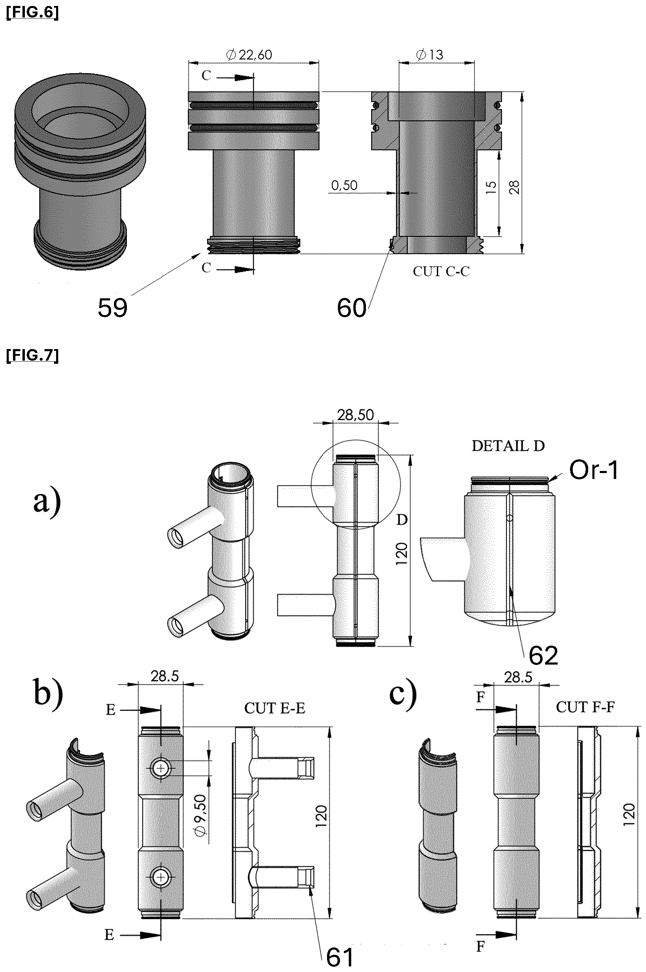

Fig. 6 is an overview of the '3a' 316L austenitic stainless steel part. '3a' 28 mm high, 22.6 m OD stainless-steel parts act as thermal insulation pieces as they are screwed (threated section 59) at the bottom inside '2a', which are at cryogenic temperature, and are coupled at the top with '2b' and '3b', which are at ambient temperature. To do so, it is made with a very thin and long section of 13 x 15 x 0.5 mm (ID x high x thickness) that limits the conductive heat transfers. In addition, these parts are filled with the nitrogen gas flow of the warm chambers 17, 19 used first for preventing ice formation, which can also increase thermal insulation. At the bottom, there is a groove 60 (groove for silicone Caf1-100) for sealing the vacuum chamber 29 with silicone CAF1-100 and two NBR O-rings 'Or-2' (ID = 20 mm, OD = 22 mm) are used to couple '3a' and '2b' in a leak-tight fashion. '4b' fits into the top hole with 'Or-3' NBR O-ring (ID = 14,5 mm, OD = 16,5 mm).

Fig. 7 is an overview of the '1b' 3D printed Rigid 4000 Formlab's resin parts. '2b' 120 mm high, 28.5 mm OD 3D printed part depicted in image a) is made with the two parts '1b-1' and '1b-2, respectively shown in image b) and c), glued together with ARALDITE 2011 - Multi-purpose two-component epoxy adhesive. A central groove 62 (groove for epoxy adhesive), appearing when the two parts are pressed on each other, was designed to allow a precise application of the epoxy. At the top and bottom, 'Or-1' NBR O-rings (ID = 22 mm, OD = 24 mm) seal the connection with '2b'. However, this connection is also reinforced with silicone sealing. '2b-1' has two vertical tubes to let the '6' 9 mm stainless steel tubes of the liquid nitrogen path go through. The tubes and '1b' are sealed for the vacuum chamber 29 at the extremity of '1b-1' tubes with silicone spread inside a dedicated groove 61 (groove for silicone Caf1-100). The two radio frequencies' DNP coils 49 are wrapped around the center, and the microwaves are shined from the side. Rigid 4000 is indeed a material transparent to microwaves and/or radio frequencies.

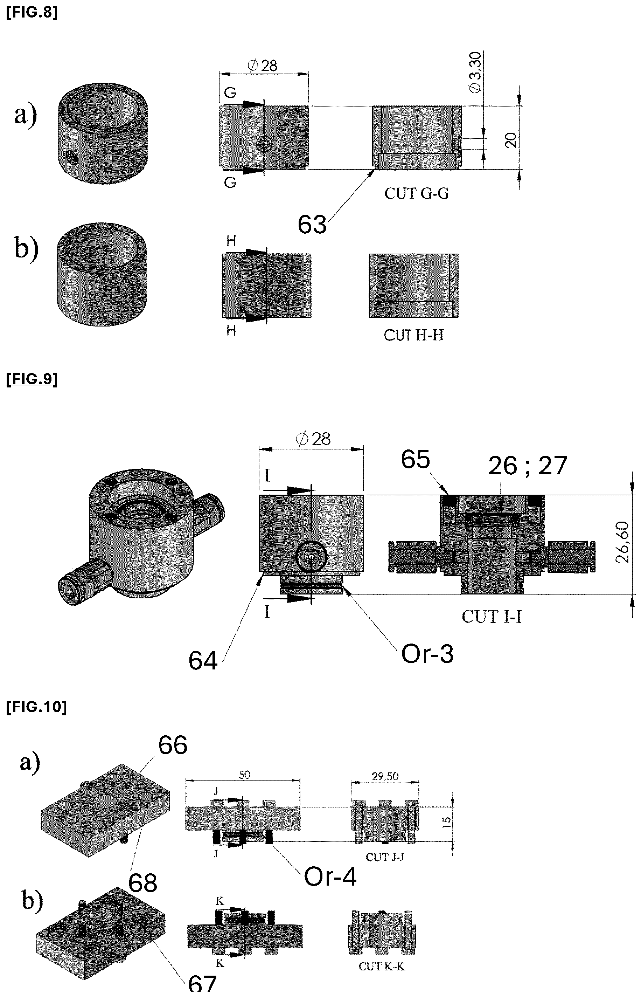

Fig. 8 is an overview of the '2b' 316L austenitic stainless steel part. Two versions of 28 mm OD, 20 mm high, '2b' part were designed, '2b-1' and '2b-2', with the only slight difference that '2b-1' has a 3.3 mm hole to solder the '6' stainless-steel tube connected to the vacuum pump. The difference is visible in images a) and b), showing respectively '2b-1' and '2b-2'. '2b' is inserted around '1b' with 'Or-1' and '3a' with 'Or-3'. As '2b-2' stays at room temperature and does not need any soldering, it can also be machined in aluminum. A dedicated groove 63 for silicone Caf1-100 is present.

Fig. 9 is an overview of the '3b' 316L austenitic stainless steel part. 26.6 mm high, 28 mm OD '3b' stainless-steel parts are closing the two warm nitrogen chambers respectively 17 or 19 with Trelleborg dynamic seals 'DynSeal' respectively 26 or 27 installed at the top. Two '7' Legris LF3000 quick-connect adaptors are screwed on each side screwed to let the nitrogen gas flow go in and out. '3b' fits into '3a' with 'Or-3' (ID = 14.5, OD = 16.5) and there is a groove 64 (groove for silicone Caf1-100) for a silicone CAF1-100 seal with '2b'. '4b' is inserted in the top hole with 'Or-4' (ID = 14.1, OD = 17.3). There are four M3 threaded holes 65 to screw the pieces together. These parts stay at room temperature and can also be machined in aluminum.

Fig. 10 is an overview of the '4b' aluminum parts. The two '4b' pieces close the two extremities of the cryostat 8. They are square aluminum plates with 50 x 29.5 x 15 mm (length x width x high) dimensions. There are two different versions, '4b-1' shown in image a) and '4b-2' in image b), that differ from their M6 holes 67. '4b-1' has through M6 holes 67 to let the long M6 rods go through, while for '4b-2', the holes are threaded to screw the rods. As a reminder, the M6 rods are used for applying pressure on the overall cryostat to stabilize its assembled structure. '4b' fits into '3b' with 'Or-4' (ID = 14.1, OD = 17.3). '4b' and '3b" are screwed together with M3 screws 66 (16 mm long recommended). Four M3 through holes 68 were drilled, on each plate.

The inner chamber walls of inner chamber 14 comprise (preferably consist of) parts '1a', '2a', and '3a' closes it. It is designed to i) hold the 10 mm sample capillary (Fig. 11) that can be slid through two cryogenic dynamic seals 24, 25 in a leak-tight fashion, ii) be transparent to microwave and radiofrequency waves for DNP-NMR manipulation, iii) have a liquid nitrogen inlet and outlet to cool down the sample to 77 K, and iv) be leak-tight to hold vacuum on the outside chamber 29 made of parts '1b-1', '1b-2', '2b-1' and '2b-2'.

Part '1a' is made of thermoplastic polymer PEEK (polyether ether ketone), with a low dielectric loss tangent constant (6.00 · 10-3)³⁷ and, therefore, mostly transparent to radiofrequencies and microwaves. It can be machined precisely and has very good mechanical properties, handling the stress brought by cooling to cryogenic temperatures. In addition, it is one of the few plastics that can handle ultra-high vacuum, which is suitable for the double-wall structure. The two '2a' parts fit into it at the top and bottom, between which sealing is performed with the high-performance silicone CAF1-100 (Bluestar Silicones). This silicon was chosen because it is leak-tight from room temperature and down to liquid helium temperatures, as it has been shown previously for sealing DNP probes.³⁸ In addition, as PEEK is shrinking more than stainless steel at 77 K (see Table 1), the gap between the two pieces interfaces reduces at cryogenic temperature, increasing the sealing robustness.

Part '2a' is made of 316L austenitic stainless steel simply because it is less expensive than PEEK and nearly non-magnetic, making it suitable to be placed between the permanent magnets 46, 47. Additionally, it does not need to be transparent to radiofrequencies and microwaves. It can also be machined precisely, has excellent mechanical properties, and can hold ultra-high vacuum. Stainless steel was also chosen as it can be soldered with high mechanical resistance and in a leak-tight way to part '5'. Part '5' is a 9 mm OD, 8.6 mm ID commercial stainless-steel tube in which the liquid nitrogen transfer line can be inserted. Part '2a' comprises a 10 mm ID Trelleborg dynamic seal (RVE-1-00100-T05S) to allow sliding of the sample capillary in a leak-tight fashion. The dynamic seal is enclosed with part '3a' screwed at the top of '2a' and CAF1-100 silicon is used at the outer interface between the two, parts to ensure that the inner cryostat chamber 14 remains leak tight.

Each wall of cryostat intermediate chambers 17, 19 comprise (preferably consist of) parts '3a' and '3b', both made of 316L stainless steel. It is filled with ambient dry nitrogen gas and comprises one additional dynamic seal 26 or 27 to ensure a leak-tight interface with ambient air while translating the sample holder 13.

Part '3a' is connected on one side with '2a' as described previously, and on the other side to part '3b'. It acts as a thermal insulation in the z-direction (which is the vertical dimension in figures 1 and 2) , with part '2a' being at cryogenic temperature, while part '3b' is at ambient temperature. To limit thermal losses, it has a thin and long section of 14 x 15 x 0.5 mm (OD · length · width). '3a' fits into '3b' at ambient temperature with 'Or-3' NBR O-ring (ID = 14,5 mm, OD = 16,5 mm), which ensures that the outer vacuum chamber 29 of the cryostat 8 remains leak-tight.

Part '3b' comprises two '7' Legris LF3000 straight threaded Adapter to push-In 4 mm M3 male that are screwed in a leak-tight way thanks to incorporated NBR O-rings to let the nitrogen gas flow go in and out. It also comprises a Trelleborg dynamic seal 26 or 27 leading to a leak-tight interface with ambient air while the sample holder 13 is static or sliding.

The two additional parts '4b-1' and '4b-2', are inserted in the top and bottom, on parts '3b', and are screwed to it with four M3 screws. These are made of aluminum as they are at ambient temperature and do not require low thermal conductivity. Moreover, aluminum is cheaper and easier to machine than stainless steel. Parts '4b' fit into parts '3b' with NBR O-rings 'OR-4' (ID = 14,1 and OD = 17,3). Four holes in the version of the part '4b-1' allow for m6 rods to go through and then be screwed in '4b-2'. This design allows us to firmly hold all the parts of the cryostat 8 together, improving both the mechanical stability and the sealing performances as it is shown in Fig. 2 and 3.

The vacuum chamber walls of outer vacuum chamber 29 comprise (preferably consist of):
- parts '1a', '2a', and '3a' previously described
- the two 316L stainless steel parts, '2b-1' and '2b-2', one of which has a pumping port to evacuate the external vacuum chamber of the cryostat 8
- two parts, '1b-1' and '1b-2', 3D-printed in rigid 4000 resin from Formlabs, that are glued with a combination of ARALDITE 2011 two-component epoxy adhesive and CAF1-100 silicone and are closing the outer vacuum chamber in a leak-tight fashion while being transparent to microwave and radio frequencies. (CAF1-100 silicon could also be used alone, but with less mechanical strength).

Part '2b' has two versions, '2b-1' and '2b-2', with the only difference being that '2b-2' has a 3.2 mm hole for soldering a 316L stainless steel tube, part '6', which is connected to the vacuum pump. One side of part '2b' is coupled with '3a' with two nitrile O-rings Or-2 (ID = 20 mm, OD = 22 mm), while the other side is going over a nitrile O-ring 'Or-4' (ID = 22 mm, OD = 24 mm) placed in a gland at the top and bottom of glued part '1b'. In order to enhance the sealing, two additional grooves on part '2b' allow one to apply CAF1-100 silicone at the interface with part '1b' after assembly. The stainless-steel tube '6' is soldered to '2b-1', and its other extremity is connected to a PFEIFFER vacuum pump DUO3 with Swagelok connectors. The '6' stainless-steel vacuum tube soldered to the cryostat 8 is connected with Swagelock connectors, PFEIFFER flexible flanges, and a KF to Swagelock adaptor to a DUO 3 vacuum pump. A pressure sensor allows to follow the vacuum reach inside the cryostat 8 while pumping and identify potential leaks.

The transfer of liquid nitrogen from a 25 L dewar to the cryostat 8 is conducted via a custom vacuum isolated transfer line (Cryofab, Inc.). The line features a vacuum-insulated stainless-steel construction with a bayonet coupling system (½" x 3" male connector) to ensure a leak-tight and thermally isolated liquid nitrogen flow. The transfer line is inserted into the dewar via a 1/2" dipstick. The dewar headspace is pressurized using nitrogen gas controlled via a pressure regulator that delivers 0.05 to 0.2 bar overpressure depending on the required liquid-nitrogen flow. A double-wall isolated glass cylinder is used to interface the output of the isolated transfer line, and the liquid nitrogen input ports of the cryostat 8. The liquid nitrogen is directed through the cryostat's double wall cooling chamber, where it maintains the sample temperature at 77 K. This setup guarantees reproducible cryogenic performance while preserving thermal isolation across the entire liquid nitrogen path.

The sliding sample holder's external structure consists of a 10 mm-long tube featuring a central transparent sapphire section 50 (that could also be made of quartz) bonded on both sides to two elongated stainless-steel tube segments, as illustrated in Fig. 11. Inside, a fine capillary 39 delivers the liquid sample to the HYPSO or HYPOP polarizing matrices 33, positioned between two fritted PEEK filters 34 located on either side of the sapphire section 50.

Thus, the sample holder structure is made of a 10 mm OD transparent sapphire tube at its center. The liquid sample is inserted through a PEEK capillary towards the center of the sample holder where the polarizing matrix 33 (HYPOP or HYPSO) is maintained between two PEEK filters 34. In figure 11:
- Part a) of figure 11 shows the whole structure and
- Part b) of figure 11 is a cut of the sample holder 13.
- Part c) of figure 11 is a close-up on the insertion section of the sample in the center.

Since the DNP process embodiment described here requires rapid cooling and heating of only the central sample holder 13, while also maintaining optical transparency, sapphire is an ideal material due to its high thermal conductivity of 1100 W·m⁻¹·K⁻¹ at 77 K (compared to 7.9 W·m⁻¹·K⁻¹ for stainless steel). To optimize cryostat performance and prevent ice formation, the rest of the external structure must be thermally insulated, minimizing heat loss both externally, which could impact the cryostat and translation system, and internally, where the sample must remain unfrozen within its capillary.

To achieve this, the stainless-steel segments have a minimal cross-sectional thickness of 0.5 mm to limit conductive heat transfer, and the internal space is maintained under vacuum. External vacuum insulation is ensured using epoxy and silicone sealing in groove 69. Internally, the central section is isolated from the vacuum in a leak-tight manner via a PEEK screw 71 and a ferrule 70, secured within a machined Kel-F component, through which the sample capillary passes.

Soldering with the "Feller's solder wire Sn60Pb40, Ø 0.5 mm, 500 g", is used between the two lateral stainless-steel tubes, '5', in which liquid nitrogen is flowing, and the '2a' parts. Indeed, as the parts are cold during the operation, these connections can be put under some stress when the overall setup is compressed. Two 3D printed parts were designed in plus to align correctly the parts for the welding. As stainless steel has very smooth surfaces and naturally oxidizes on them, it is a metal on which it is difficult to make the tin-lead adhere even after cleaning. To remove these oxides, which act as a protective layer, a small quantity of liquid flux is spread on the soldering surface in a precise way. It can be deposited with a micropipette or by capillarity with a small plastic tube. Then, the tin can be melted on the surface with an iron tip. It is often recommended to do a pre-tinning of the parts' surfaces independently before welding them together. Pre-tinned surfaces take solder more easily. If there are still some areas not well prepared, tin may form beads instead of spreading over the stainless steel, making them easy to locate and then pre-tin again.

For the flux, Stannol's highly active flux concentrate is chosen, "50505 Nirosta", as it was specially developed for stainless steel. However, like many fluxes, it has a highly corrosive effect that can create in the welding tiny cracks leading to leaks. To prevent this phenomenon, residues after the soldering must be cleaned with water (ideally warm). To melt the tin, the iron tip was heated up at 350°C. Going to a higher temperature, close to 400°C, would lead to inefficient soldering as the flux degraded too fast, preventing the tin from wetting the stainless steel. "Weller LT BX 2.4 mm Bent Screwdriver Soldering Iron Tip" has been used to perform precise soldering. The soldering station is "WT 1012, 95W, 230V" and is also produced by the company. Below table 2 summarizes all the relevant information of the different tools used for soldering.

**Table 2. References of the tools and devices used for the stainless-steel soldering.**

| Tool | Manufacture r | Provider | Manufacturer Part Number |
|---|---|---|---|
| Solder wire, leaded, Sn60Pb40, Ø 0.5 mm, 500 g | Felder | Buerklin | 14610530 |
| Weller soldering station, WT 1012, 95W, 230V | Weller | RS Component s | T0053440399 N |
| Weller LT BX 2.4 mm Bent Screwdriver Soldering Iron Tip | Weller | RS Component s | T0054444299 |
| Weller soldering iron tip LT GW1, Mini-wave, LT series, 1.4 mm | Weller | RS Component s | T0054441099 |
| Weller LT M 3.2 mm Screwdriver Soldering Iron Tip | Weller | RS Component s | T0054441599 |
| Soldering Concentrate 5050S Nirosta | Stannol | Stannol | not provided |

The epoxy glue, "ARALDITE 2011 - Multi-purpose two-component epoxy adhesive" manufactured by HUNTSMAN, bonds together the two 3D printed parts, '1b-1' and '1b-2'. The references of the epoxy can be found in Table 3. It is a room-temperature curing adhesive of high strength and toughness, suitable for bonding a wide variety of metals, ceramics, glass, rubber, rigid plastics, and most other materials in common use. To prepare it, the inventors mix the resin and hardener, Araldite 2011/A and Araldite 2011/B, with equal volume amounts on a clean plastic surface. Then, the mixture is stirred thoroughly for 1 to 2 minutes with a micropipette. To obtain stronger and more durable joints, it is recommended to mechanically abrade the surfaces, like with sandpaper, and then degrease them again before applying the glue. As the Araldite mixture is quite viscous once prepared, grooves are designed in the pieces to let the epoxy glue spread inside after being deposited with a micropipette. Having grooves allow us to obtain clean and precise applications of the epoxy. Finally, the last step is just to wait until the cure of the adhesive is finished. The curing time at room temperature is quite long, 7 to 10 hours at 23°C. Thus, it is important to take into account the orientation of the glued surfaces while curing. A bad orientation can lead to the viscous mixture going into unexpected areas. It is also possible even advised to reduce the curing time significantly by increasing the temperature of the cure, for example, with an oven. At 100°C, the time is decreasing to 7 to 10 minutes. Epoxy is hard to remove and may require complex methods. It is removed by burning it precisely with solder tips. Therefore, it is essential to take precautions when choosing where to apply it, as removal can damage the bonded surfaces or destroy the parts.

A good alternative to epoxy can be silicone in order to bond two parts that are not subject to continuous stress. Unlike structural adhesive, excessive tension or significant shear can weaken it and cause rupture or detachment. However, its flexible and elastic properties make it resistant to small deformation, which is perfect for connections between pieces that shrink differently at cold temperatures. For the cryostat 8, these properties are used to seal together '1a' PEEK and '2a' stainless steel parts. The preparation process of the bonding surfaces for silicone is like epoxy: degreasing, mechanical abrasion, degreasing again, and drying. Also, it is again recommended to design grooves for spreading the silicone, like epoxy. The silicone is then applied precisely with its bottle's tip on the bonding surface, and finally, by wearing a slightly wet plastic glove, the inventors spread it inside the groove with their fingers. To make the final silicone seal as clean as possible, the inventors are putting tape around the bonding surfaces to avoid having the silicone spread in unexpected areas. The tape is removed once the step of putting the silicone is finished and it is still viscous. If removed after solidification, the sealing can be degraded and this may create leaks. The references of the silicone can be found in below table 3.

**Table 3. References of the silicone and epoxy adhesive used for the cryostat assembly**

| Tool | Manufacturer | Provider | reference |
|---|---|---|---|
| High performance silicone bonding assembly sealing | Bluestar Silicones | hd-outillage.com | CAF1-100 |
| ARALDITE 2011 - Multi-purpose two-component epoxy adhesive | HUNTSMAN | Silicone & Composite | ARALDITE 2011 |

The last and most used sealing connection on the cryostat 8 is made with seals. Two different types of seals are used: PTFE dynamic seals for seals 24, 25, 26, 27, and static Nitrile Rubber (NBR) O-rings for seals Or-1, Or-2, Or-3 and Or-4.

NBR can only be used for room temperature connections, as this material shrinks and also becomes brittle at cryogenic conditions. PTFE, however, can be used in both contexts, which justifies the choice of this material to seal the cryogenic and warm nitrogen gas chambers. Reaching good isolation with seals depends mainly on the dimension of the gland machined. For the Trelleborg's dynamic seal, the dimensions given by the technical sheet of the company is followed. For static O-rings, three parameters must be considered in the design. First, the O-ring squeeze compression, so the percentage of reduction in the O-ring's cross-sectional diameter when it is installed in a gland and pressed. Then, the O-ring installed stretches: the increase in its diameter when it is installed onto a groove that is larger than its inner diameter. Finally, the O-ring gland fill, which is the ratio of the O-ring volume and the gland volume. Their values differ from the material. Below table 4 summarizes them for NBR O-rings, and the values for PTFE ones are added, as a comparison. Moreover, the gland surfaces should be smooth and free of defects and its corners should be chamfered to avoid abrasion and wear on the O-ring.

**Table 4. Parameters' values recommendations for groove design of Nitrile Rubber and PTFE O-rings**

| Material | Squeeze compression (%) | Strech (%) | Gland fill (%) |
|---|---|---|---|
| Nitrile Rubber | 5 | 30 | 100 |
| PTFE | 5 | 20 | 70 |

The described embodiment of DNP (dynamic nuclear polarization) device 10 according to the invention comprises the previously described cryostat 8.

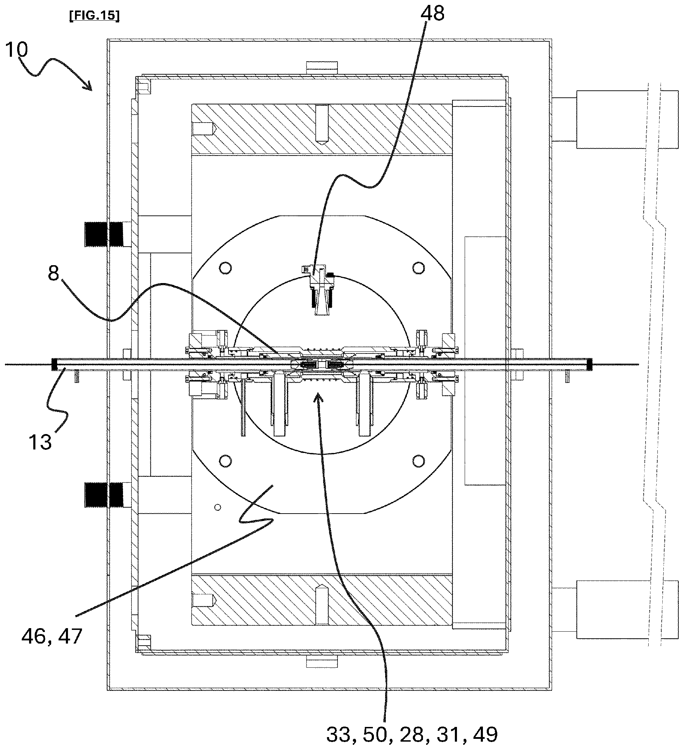

Device 10 comprises means 46 for subjecting the first intermediate chamber 17, and/or the second intermediate chamber 19 and/or the heating chamber 37 (preferably all chambers 17, 19, 37 as illustrated in figure 15) to a magnetic field greater than 50mT. This allows to maintain polarization of the one or more molecules to be examined until unfreezing in the heating chamber 37 the one or more molecules to be examined back into a liquid medium.

Device 10 comprises means 47 for subjecting the inner chamber 14 to a magnetic field greater than 100mT, preferably greater than 900 mT.

Means 46 and 47 are the same means.

Preferably, means 46 comprise at least two magnetic poles of permanent magnets; and preferably means 47 comprise the same at least two magnetic poles of permanent magnets.

The difference in the strength of the magnetic field can be achieved by the spatial arrangement of the chambers 17, 19 compared to 14. While 14 is more in the center of the magnetic field, 17 and 19 are arranged at the edge.

Device 10 comprises means 48 (comprising typically a DNP microwaves horn) for subjecting the inner chamber 14 to microwaves having at least one frequency between 1 GHz and 300 GHz, through the polarizing part 28 of the inner chamber walls and the polarizing part 31 of the vacuum chamber walls (and part 50 of conduit 32 when the sample holder 13 is in its inner position). This frequency range allows the transfer of polarization from the agent 33 to the one or more molecules to be examined or to an intermediate type of molecule (in case of cross polarization).

Device 10 comprises, optionally but preferably, means 49 (comprising typically double tuned radio frequency coils surrounding the polarizing part 28 of the inner chamber walls and the polarizing part 31 of the vacuum chamber walls (and part 50 of conduit 32 when the sample holder 13 is in its inner position)) for subjecting the inner chamber 14 to radio frequencies having at least one frequency between 1 MHz and 300 MHz, through the polarizing part 28 of the inner chamber walls and the polarizing part 31 of the vacuum chamber walls (and part 50 of conduit 32 when the sample holder 13 is in its inner position). This frequency range allows cross polarization from the intermediate type of molecules to the one or more molecules to be examined.

Fig. 3 is an overview of the fully assembled cryostat 8. The sealing of the external structure is achieved by a silicone, while the overall assembly is held under pressure by four long M6 rods. Fig. 3 presents the 3D design, showcasing the various input and output connections, the positioning of the double-tuned RF coil configuration 49, and the DNP microwave horn 48, which enables the hyperpolarization process at the sample's center.

Fig. 15 is an overview of the 1 T benchtop DNP polarizer 10. The polarizer 10 is equipped with 1 T permanent magnet 46, 47 (but that could also be a more complex Halbach structure) that is temperature stabilized at 301 K by 6 PID (Proportional-integral-derivative) controlled heating materials.

The described embodiment of NMR (Nuclear Magnetic Resonance) system 11 according to the invention comprises the previously described DNP device 10.

The NMR system 11 further comprises a magnetic resonance examination device 51 arranged for acquiring NMR data, the fluid circuit 35 extending outside the sample chamber 12 and through the magnetic resonance examination device 51, the fluid circuit 35 being a flow-through fluid circuit arranged for:
- producing a portion of hyperpolarized liquid in the sample chamber 12 (more precisely in the agent 33 while means 47 (and optionally 46) generate a magnetic field and while the agent 33 is inside the inner chamber 14 and while means 48 (and optionally 49 simultaneously in case or cross polarization) emit in their respective frequency range), or providing this portion of hyperpolarized liquid in the circuit 35
- while using in the magnetic resonance examination device 51 another portion of hyperpolarized liquid previously produced in the sample chamber 12.

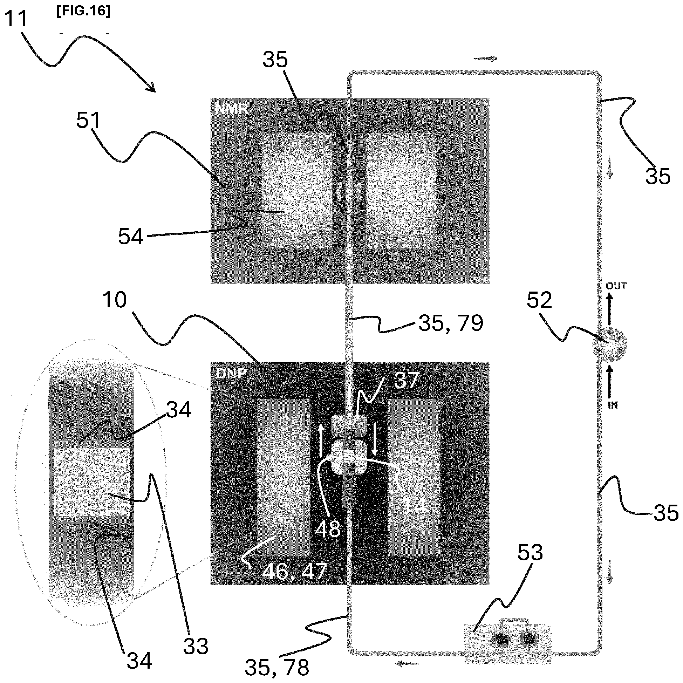

Fig. 16 is a scheme of the system 11 with its different parts:
- firstly, the ~600 µL sample loop circuit 35 is filled with the solution through ports IN and OUT of a six-way port valve 52. When the loop is filled, the valve 52 turns and closes the loop.
- A portion of the sample impregnated in the hyperpolarizing mesoporous material 33, retained between two filters 34, is then frozen at 77 K in the cryostat 8, where DNP occurs upon frequency-modulated microwave irradiation (µwave horn 48) at magnetic field of 1 Tesla (means 46, 47) .
- After the maximum level of polarization is reached, the sample holder 13 (also called DNP flow cell 13) is lifted with means 36 (a stepper motor not represented here) to the second intermediate chamber 19 then to the heating chamber 37 (also called sample melting system), and the solution is rapidly melted.
- The high-pressure dosing pump 53 is then activated to move the liquid in the sample loop 35, thus transferring the hyperpolarized portion of the solution into the NMR coil of the NMR device 51. Here, the liquid state analysis occurs at 2 Tesla (created by magnet 54) while the DNP flow cell 13 is lifted down again to freeze another portion of the sample and perform simultaneous DNP.

Each part 78, 79 of the circuit 35 upstream and downstream the sample chamber 12 is made of a flexible tube or conduit (typically flexible PEEK tubing).

The typical embodiment of a process according to the invention is implemented in:
- the device 10, and comprises a dissolution dynamic nuclear polarization or a cross polarization step inside the sample chamber 12 for producing or providing a hyperpolarized liquid as previously described, or
- the system 11, and comprises:
   ∘ a dissolution dynamic nuclear polarization or a cross polarization step inside the sample chamber 12 for producing or providing a hyperpolarized liquid as previously described, and
   ∘ preferably simultaneously, analyzing in the magnetic resonance examination device 51 another portion of hyperpolarized liquid previously produced in the sample chamber 12.

We have thus detailed the design and implementation of a compact flow cryostat 8, specifically developed to enable the translation of a sample holder 13 through its internal structure. This cryostat 8 is designed to fit between the two pole pieces of a permanent magnet of the 1 T DNP benchtop polarizer 10, which are separated by a distance of 30 mm. The central structure is composed of materials transparent to radiofrequencies and microwaves, namely PEEK and Formlab's rigid 4000 resin, and features an inner cryogenic chamber 14 filled with liquid nitrogen. This ensures full compatibility with DNP and CP experiments. In addition, a vacuum-pumped double wall chamber 29 combined with low thermal conductive stainless steel parts guarantees an effective thermal isolation of the external structure to prevent unwanted field drifting of the magnets, which can be induced by unstable temperature. Furthermore, the integration of four dynamic seals 24, 25, 26, 27 and two warm nitrogen gas chambers 17, 19 enables the rapid and secure transfer of hyperpolarized samples to a dedicated melting unit 37 for subsequent liquid-state NMR analysis.

The compact sample-translation flow-cryostat 8 is thus placed in the 1 T permanent magnet 46, 47 while operating at 77 K. The new design ensures transparency to both microwaves for DNP and radio-frequency waves for CP. It enables a 10 mm OD sample holder 13 translation to a dedicated melting unit 37. This new cryostat 8 is a key step towards the new approach which aims at enabling hyperpolarization in a way that is for the first time i) dilution-free though fast melting, ii) contamination-free by extracting the liquid sample from the polarizing matrices, and iii) recyclable by flowing the pure solution back to the DNP polarizer.

The custom stainless-steel and PEEK sliding-sample cryostat 8 with a flow-through capillary unit 13 is designed to overcome the challenges of the prior art. The cryostat features a cooling unit 14 reaching temperatures as low as 77 K, while simultaneously being transparent to microwave and radio-frequency irradiation. By means of DNP in polarizing matrices (preferably HYPOPs), sensitivity in ¹H and other heteronuclei (e.g. ¹³C) can be boosted by two orders of magnitude compared to the thermal equilibrium signal. A dedicated rapid melting mechanism 37 , operating outside the cooling unit 14, transitions the sample to liquid-state without dilution or contamination. A pumping system 53 then delivers the hyperpolarized sample to a standard NMR spectrometer 51 for detection. This design enables precise thermal control, efficient polarization transfer, and recyclable sample handling, until now unprecedented in the field of hyperpolarization using DNP.

The closed loop circuit 35 aims to facilitate liquid-state NMR acquisition with dilution-free, contamination-free, and recyclable hyperpolarization.

Of course, the invention is not limited to the examples which have just been described and numerous amendments can be made to these examples without exceeding the scope of the invention.

Of course, the different characteristics, forms, variants and embodiments of the invention can be combined with each other in various combinations to the extent that they are not incompatible or mutually exclusive.

### Cited References

(1) Abragam, A.; Goldman, M. Principles of Dynamic Nuclear Polarisation. Rep. Prog. Phys. 1978, 41 (3), 395-467. https://doi.org/10.1088/0034-4885/41/3/002.
(2) Eills, J.; Budker, D.; Cavagnero, S.; Chekmenev, E. Y.; Elliott, S. J.; Jannin, S.; Lesage, A.; Matysik, J.; Meersmann, T.; Prisner, T.; Reimer, J. A.; Yang, H.; Koptyug, I. V. Spin Hyperpolarization in Modern Magnetic Resonance. Chem. Rev. 2023, 123 (4), 1417-1551. https://doi.org/10.1021/acs.chemrev.2c00534.
(3) Wenckebach, W. T. Essentials of Dynamic Nuclear Polarization; Spindrift Publications, 2016.
(4) Elliott, S. J.; Stern, Q.; Ceillier, M.; El Daraï, T.; Cousin, S. F.; Cala, O.; Jannin, S. Practical Dissolution Dynamic Nuclear Polarization. Progress in Nuclear Magnetic Resonance Spectroscopy 2021, 126-127, 59-100. https://doi.org/10.1016/j.pnmrs.2021.04.002.
(5) Wenckebach, W. T. The Solid Effect. Appl Magn Reson 2008, 34 (3-4), 227. https://doi.org/10.1007/s00723-008-0121-9.
(6) Hovav, Y.; Feintuch, A.; Vega, S. Theoretical Aspects of Dynamic Nuclear Polarization in the Solid State - The Cross Effect. Journal of Magnetic Resonance 2012, 214, 29-41. https://doi.org/10.1016/j.jmr.2011.09.047.
(7) Hovav, Y.; Feintuch, A.; Vega, S. Theoretical Aspects of Dynamic Nuclear Polarization in the Solid State - The Solid Effect. Journal of Magnetic Resonance 2010, 207 (2), 176-189. https://doi.org/10.1016/j.jmr.2010.10.016.
(8) Wenckebach, W. Th. Dynamic Nuclear Polarization via the Cross Effect and Thermal Mixing: A. The Role of Triple Spin Flips. Journal of Magnetic Resonance 2019, 299, 124-134. https://doi.org/10.1016/j.jmr.2018.12.018.
(9) Borghini, M. Spin-Temperature Model of Nuclear Dynamic Polarization Using Free Radicals. Phys. Rev. Lett. 1968, 20 (9), 419-421. https://doi.org/10.1103/PhysRevLett.20.419.
(10) Khutsishvili, G. R. SPIN DIFFUSION. Sov. Phys. Usp. 1966, 8 (5), 743. https://doi.org/10.1070/PU1966v008n05ABEH003035.
(11) Atsarkin, V. A.; Demidov, V. V. Nuclear Magnetic Relaxation and Spin Diffusion in the Local Fields of Paramagnetic Centers. 1980.
(12) Singh, K.; Blümich, B. NMR Spectroscopy with Compact Instruments. TrAC Trends in Analytical Chemistry 2016, 83, 12-26. https://doi.org/10.1016/j.trac.2016.02.014.
(13) Ravera, E.; Luchinat, C.; Parigi, G. Basic Facts and Perspectives of Overhauser DNP NMR. Journal of Magnetic Resonance 2016, 264, 78-87. https://doi.org/10.1016/j.jmr.2015.12.013.
(14) Ardenkjær-Larsen, J. H.; Fridlund, B.; Gram, A.; Hansson, G.; Hansson, L.; Lerche, M. H.; Servin, R.; Thaning, M.; Golman, K. Increase in Signal-to-Noise Ratio of > 10,000 Times in Liquid-State NMR. Proc. Natl. Acad. Sci. U.S.A. 2003, 100 (18), 10158-10163. https://doi.org/10.1073/pnas.1733835100.
(15) Overhauser, A. W. Polarization of Nuclei in Metals. Phys. Rev. 1953, 92 (2), 411. https://doi.org/10.1103/PhysRev.92.411.
(16) Kircher, R.; Hasse, H.; Münnemann, K. High Flow-Rate Benchtop NMR Spectroscopy Enabled by Continuous Overhauser DNP. Anal. Chem. 2021, 93 (25), 8897-8905. https://doi.org/10.1021/acs.analchem.1c01118.
(17) Kouňil, K.; Kouřlová, H.; Bartram, S.; Levitt, M. H.; Meier, B. Scalable Dissolution-Dynamic Nuclear Polarization with Rapid Transfer of a Polarized Solid. Nat Commun 2019, 10 (1), 1733. https://doi.org/10.1038/s41467-019-09726-5.
(18) Sharma, M.; Janssen, G.; Leggett, J.; Kentgens, A. P. M.; van Bentum, P. J. M. Rapid-Melt Dynamic Nuclear Polarization. Journal of Magnetic Resonance 2015, 258, 40-48. https://doi.org/10.1016/j.jmr.2015.06.007.
(19) Joo, C.-G.; Hu, K.-N.; Bryant, J. A.; Griffin, R. G. In Situ Temperature Jump High-Frequency Dynamic Nuclear Polarization Experiments: Enhanced Sensitivity in Liquid-State NMR Spectroscopy. J. Am. Chem. Soc. 2006, 128 (29), 9428-9432. https://doi.org/10.1021/ja0611947.
(20) Bocquelet, C.; Rougier, N.; Le, H.-N.; Veyre, L.; Thieuleux, C.; Melzi, R.; Purea, A.; Banks, D.; Kempf, J. G.; Stern, Q.; Vaneeckhaute, E.; Jannin, S. Boosting1 H and13 C NMR Signals by Orders of Magnitude on a Bench. Sci. Adv. 2024, 10 (49), eadq3780. https://doi.org/10.1126/sciadv.adq3780.
(21) Khutsishvili, G. R. SPIN DIFFUSION AND MAGNETIC RELAXATION OF NUCLEI. Zhur. Eksptl'. i Teoret. Fiz. 1962, Vol: 42.
(22) Vaneeckhaute, E.; Bocquelet, C.; Bellier, L.; Le, H.-N.; Rougier, N.; Jegadeesan, S. A.; Vinod-Kumar, S.; Mathies, G.; Veyre, L.; Thieuleux, C.; Melzi, R.; Banks, D.; Kempf, J.; Stern, Q.; Jannin, S. Full Optimization of Dynamic Nuclear Polarization on a 1 Tesla Benchtop Polarizer with Hyperpolarizing Solids. Phys. Chem. Chem. Phys. 2024, 26 (33), 22049-22061. https://doi.org/10.1039/D4CP02022G.
(23) Barnes, A. B.; Mak-Jurkauskas, M. L.; Matsuki, Y.; Bajaj, V. S.; van der Wel, P. C. A.; DeRocher, R.; Bryant, J.; Sirigiri, J. R.; Temkin, R. J.; Lugtenburg, J.; Herzfeld, J.; Griffin, R. G. Cryogenic Sample Exchange NMR Probe for Magic Angle Spinning Dynamic Nuclear Polarization. Journal of Magnetic Resonance 2009, 198 (2), 261-270. https://doi.org/10.1016/j.jmr.2009.03.003.
(24) Scott, F. J.; Alaniva, N.; Golota, N. C.; Sesti, E. L.; Saliba, E. P.; Price, L. E.; Albert, B. J.; Chen, P.; O'Connor, R. D.; Barnes, A. B. A Versatile Custom Cryostat for Dynamic Nuclear Polarization Supports Multiple Cryogenic Magic Angle Spinning Transmission Line Probes. Journal of Magnetic Resonance 2018, 297, 23-32. https://doi.org/10.1016/j.jmr.2018.10.002.
(25) Comment, A.; Van Den Brandt, B.; Uffmann, K.; Kurdzesau, F.; Jannin, S.; Konter, J. A.; Hautle, P.; Wenckebach, W. Th.; Gruetter, R.; Van Der Klink, J. J. Design and Performance of a DNP Prepolarizer Coupled to a Rodent MRI Scanner. Concepts Magn Reson 2007, 31B (4), 255-269. https://doi.org/10.1002/cmr.b.20099.
(26) Thurber, K.; Tycko, R. Low-Temperature Dynamic Nuclear Polarization with Helium-Cooled Samples and Nitrogen-Driven Magic-Angle Spinning. Journal of Magnetic Resonance 2016, 264, 99-106. https://doi.org/10.1016/j.jmr.2016.01.011.
(27) Tagami, K.; Thicklin, R.; Jain, S.; Equbal, A.; Li, M.; Zens, T.; Siaw, A.; Han, S. Design of a Cryogen-Free High Field Dual EPR and DNP Probe. Journal of Magnetic Resonance 2023, 347, 107351. https://doi.org/10.1016/j.jmr.2022.107351.
(28) Ardenkjaer-Larsen, J. H.; Bowen, S.; Petersen, J. R.; Rybalko, O.; Vinding, M. S.; Ullisch, M.; Nielsen, N. C. Cryogen-Free Dissolution Dynamic Nuclear Polarization Polarizer Operating at 3.35 T, 6.70 T, and 10.1 T. Magn Reson Med 2019, 81 (3), 2184-2194. https://doi.org/10.1002/mrm.27537.
(29) Capozzi, A. Design and Performance of a Small Bath Cryostat with NMR Capability for Transport of Hyperpolarized Samples. Sci Rep 2022, 12 (1), 19260. https://doi.org/10.1038/s41598-022-23890-7.
(30) Ekin, J. Experimental Techniques for Low-Temperature Measurements: Cryostat Design, Material Properties and Superconductor Critical-Current Testing; Oxford University Press, 2006. https://doi.org/10.1093/acprof:oso/9780198570547.001.0001.
(31) Cryostat Design: Case Studies, Principles and Engineering; Weisend Ii, J. G., Ed.; International Cryogenics Monograph Series; Springer International Publishing: Cham, 2016. https://doi.org/10.1007/978-3-319-31150-0.
(32) Narwal, P.; Lorz, N.; Minaei, M.; Jannin, S.; Kouřil, K.; Gossert, A.; Meier, B. Bullet-DNP Enables NMR Spectroscopy of Pyruvate and Amino Acids at Nanomolar to Low Micromolar Concentrations. Anal. Chem. 2024, 96 (37), 14734-14740. https://doi.org/10.1021/acs.analchem.4c00618.
(33) Albert, B. J.; Pahng, S. H.; Alaniva, N.; Sesti, E. L.; Rand, P. W.; Saliba, E. P.; Scott, F. J.; Choi, E. J.; Barnes, A. B. Instrumentation for Cryogenic Magic Angle Spinning Dynamic Nuclear Polarization Using 90 L of Liquid Nitrogen per Day. Journal of Magnetic Resonance 2017, 283, 71-78. https://doi.org/10.1016/j.jmr.2017.08.014.
(34) Lee, D.; Bouleau, E.; Saint-Bonnet, P.; Hediger, S.; De Paëpe, G. Ultra-Low Temperature MAS-DNP. Journal of Magnetic Resonance 2016, 264, 116-124. https://doi.org/10.1016/j.jmr.2015.12.010.
(35) Joo, C.-G.; Casey, A.; Turner, C. J.; Griffin, R. G. In Situ Temperature-Jump Dynamic Nuclear Polarization: Enhanced Sensitivity in Two Dimensional 13C-13C Correlation Spectroscopy in Solution. J. Am. Chem. Soc. 2009, 131 (1), 12-13. https://doi.org/10.1021/ja805521y.
(36) van Meerten, S. G. J.; Janssen, G. E.; Kentgens, A. P. M. Rapid-Melt DNP for Multidimensional and Heteronuclear High-Field NMR Experiments. Journal of Magnetic Resonance 2020, 310, 106656. https://doi.org/10.1016/j.jmr.2019.106656.
(37) Sun, H.; Lv, Y.; Zhang, C.; Zuo, X.; Li, M.; Yue, X.; Jiang, Z. Materials with Low Dielectric Constant and Loss and Good Thermal Properties Prepared by Introducing Perfluorononenyl Pendant Groups onto Poly(Ether Ether Ketone). RSC Adv. 2018, 8 (14), 7753-7760. https://doi.org/10.1039/C7RA13600E.
(38) Baudin, M.; Vuichoud, B.; Bornet, A.; Bodenhausen, G.; Jannin, S. A Cryogen-Consumption-Free System for Dynamic Nuclear Polarization at 9.4 T. Journal of Magnetic Resonance 2018, 294, 115-121. https://doi.org/10.1016/j.jmr.2018.07.001.
(39) Bradley, P. E.; Radebaugh, R. PROPERTIES OF SELECTED MATERIALS AT CRYOGENIC TEMPERATURES.
(40) Rule, D. L.; Sparks, L. L. Low-Temperature Thermal Conductivity of Composites: Alumina Fiberepoxy and Alumina fiberPEEK, 0 ed.; NIST IR 89-3914; National Institute of Standards and Technology: Gaithersburg, MD, 1989; p NIST IR 89-3914. https://doi.org/10.6028/NIST.IR.89-3914.
(41) Wang, Z.; Bailey, W.; Song, J.; Huang, L.; Yang, Y. Evaluating the Potential of Thermoplastic Polymers for Cryogenic Sealing Applications: Strain Rate and Temperature Effects. arXiv June 3, 2024. https://doi.org/10.48550/arXiv.2406.01165.

## Claims

1. Cryostat (8) comprising a sample chamber (12) arranged for receiving a sample holder (13) sliding inside the sample chamber, said sample chamber comprising :
- an inner chamber (14), arranged for receiving the sample holder sliding inside the inner chamber between a first opening (15) and a second opening (16) of the inner chamber,
- a first intermediate chamber (17) arranged for receiving the sample holder sliding inside the first intermediate chamber between the first opening of the inner chamber and a first exit (18) of the cryostat,
- a second intermediate chamber (19) arranged for receiving the sample holder sliding inside the second intermediate chamber between the second opening of the inner chamber and a second exit (20) of the cryostat,
the cryostat comprising means (21) for cooling the inner chamber to a cryogenic temperature below 120 K,
**characterized in that** :
the cryostat comprises means for maintaining (22) the first intermediate chamber at a first warm temperature above the cryogenic temperature ,
the cryostat comprises means for maintaining (23) the second intermediate chamber at a second warm temperature above the cryogenic temperature,
the cryostat comprises a first inner sliding seal (24) between the inner chamber and the first intermediate chamber, said first inner sliding seal being arranged for allowing sliding the sample holder through the first inner sliding seal while being leak-tight to fluids contained in the inner chamber and in the first intermediate chamber,
the cryostat comprises a second inner sliding seal (25) between the inner chamber and the second intermediate chamber, said second inner sliding seal being arranged for allowing sliding the sample holder through the second inner sliding seal while being leak-tight to fluids contained in the inner chamber and in the second intermediate chamber.

2. Cryostat according to claim 1, **characterized in that** the cryostat comprises:
- at the first exit, a first outside sliding seal (26) , said first outside sliding seal being arranged for allowing sliding the sample holder through the first outside sliding seal while being leak-tight to fluids contained in the first intermediate chamber and outside the first intermediate chamber, and/or
- at the second exit, a second outside sliding seal (27), said second outside sliding seal being arranged for allowing sliding the sample holder through the second outside sliding seal while being leak-tight to fluids contained in the second intermediate chamber and outside the second intermediate chamber.

3. Cryostat according to any one of the previous claims, **characterized in that** the inner chamber is delimited by inner chamber walls of which a polarizing part (28) is transmissive to microwaves and/or radio frequencies, preferably having an intensity transmission coefficient of at least 50% for at least one frequency between 1 GHz and 300 GHz, and preferably for at least one frequency between 1 MHz and 300 MHz.

4. Cryostat according to any one of the previous claims, **characterized in that** the cryostat comprises:
- a vacuum chamber (29) , surrounding all the inner chamber, the first inner sliding seal, at least a part of the first intermediate chamber, the second inner sliding seal and at least a part of the second intermediate chamber,
- means (30) for creating an isolating vacuum inside the vacuum chamber.

5. Cryostat according to claim 4, **characterized in that** the vacuum chamber is delimited by vacuum chamber walls of which a polarizing part (31) is transmissive to microwaves and/or radio frequencies, preferably having an intensity transmission coefficient of at least 50% for at least one frequency between 1 GHz and 300 GHz, and preferably for at least one frequency between 1 MHz and 300 MHz.

6. Cryostat according to any one of the previous claims, **characterized in that** the means for cooling the inner chamber comprise means for injecting a cryogenic fluid inside the inner chamber.

7. Cryostat according to any one of the previous claims, **characterized in that**:
- the means for maintaining the first intermediate chamber at a temperature above the cryogenic temperature comprise means for injecting a warm gas at the first warm temperature inside the first intermediate chamber, and/or
- the means for maintaining the second intermediate chamber at a temperature above the cryogenic temperature comprise means for injecting a warm gas at the second warm temperature inside the second intermediate chamber.

8. Cryostat according to any one of the previous claims, further comprising the sample holder inside the sample chamber.

9. Cryostat according to the previous claim, **characterized in that** the sample holder comprises a conduit (32):
- arranged for containing a solvent with one or more molecules to be examined,
- in which is enclosed a polarization agent containing paramagnetic species,
the conduit being arranged to allow the solvent and the one or more molecules to be examined to flow inside the conduit along a fluid circuit (35) so that the one or more molecules to be examined can go in and out of the polarization agent.

10. Cryostat according to claim 9, **characterized in that** at least the portion of the conduit surrounding the polarization agent is made from a material transmissive to microwaves and/or radio frequencies, preferably having an intensity transmission coefficient of at least 50 for at least one frequency between 1 GHz and 300 GHz, and preferably for at least one frequency between 1 MHz and 300 MHz.

11. Cryostat according to claim 9 or 10, **characterized in that** the cryostat comprises moving means arranged for moving the sample holder inside the sample chamber so that the sample holder can have at least the following positions:
- an inner position in which the polarization agent is located inside the inner chamber,
- at least one position among:
∘ a first intermediate position in which the polarization agent is located inside the first intermediate chamber,
∘ a second intermediate position in which the polarization agent is located inside the second intermediate chamber.

12. Cryostat according to claim 11, **characterized in that** the cryostat further comprises a heating chamber (37) in communication with the second intermediate chamber, the moving means being arranged for moving the sample holder so that the sample holder can have a heating position in which the polarization agent is located inside the heating chamber, the cryostat comprising heating means (38) arranged for heating at least a part of the sample holder inside the heating chamber.

13. Cryostat according to any one of claims 11 or 12, **characterized in that** the conduit comprises:
- At least one among :
∘ A first set comprising:
▪ upstream the portion of the fluid circuit including the polarization agent, an upstream capillary (39) arranged for allowing the solvent and the one or more molecules to be examined to flow inside the conduit along the fluid circuit before reaching the polarization agent,
▪ an upstream conduit vacuum chamber (40) surrounding the upstream capillary, so that when the sample holder is in its second intermediate position, the upstream capillary is isolated from the inner chamber by the upstream conduit vacuum chamber,
▪ means (41) for creating an isolating vacuum inside upstream conduit vacuum chamber ,
∘ a second set comprising:
▪ downstream the portion of the fluid circuit including the polarization agent, a downstream capillary (42) arranged for allowing the solvent and the one or more molecules to be examined to flow inside the conduit along the fluid circuit after leaving the polarization agent,
▪ a downstream conduit vacuum chamber (43) surrounding the downstream capillary, so that when the sample holder is in its first intermediate position, the downstream capillary is isolated from the inner chamber by the downstream conduit vacuum chamber,
▪ means (44) for creating an isolating vacuum inside downstream conduit vacuum chamber.

14. Dynamic nuclear polarization device (10) comprising the cryostat according to any one of claims 9 to 13, said dynamic nuclear polarization device further comprising :
- means for subjecting (46) the first intermediate chamber, and/or the second intermediate chamber to a magnetic field greater than 50mT, and/or
- means (47) for subjecting the inner chamber to a magnetic field greater than 100mT, and/or
- means (48) for subjecting the inner chamber to microwaves having at least one frequency between 1 GHz and 300 GHz, and/or
- means (49) for subjecting the inner chamber to radio frequencies having at least one frequency between 1 MHz and 300 MHz.

15. Nuclear magnetic resonance system (11) comprising the dynamic nuclear polarization device according to claim 14, **characterized in that** the nuclear magnetic resonance system comprises a magnetic resonance examination device (51), the fluid circuit extending outside the sample chamber and through the magnetic resonance examination device, the fluid circuit being a flow-through fluid circuit arranged for producing a portion of hyperpolarized liquid in the sample chamber while using in the magnetic resonance examination device another portion of hyperpolarized liquid previously produced in the sample chamber.
